(19) Europäisches Patentamt
European Patent Office
Office européen des brevets

(11) **EP 4 787 663 A1**

(12) **EUROPEAN PATENT APPLICATION**
published in accordance with Art. 153(4) EPC

(43) Date of publication:
**05.08.2026 Bulletin 2026/32**

(21) Application number: **25747034.4**

(22) Date of filing: **05.08.2025**

(51) International Patent Classification (IPC):
*H02J 7/00* (2026.01)    *G01R 19/165* (2006.01)
*H04R 1/10* (2026.01)    *H02J 7/34* (2006.01)

(52) Cooperative Patent Classification (CPC):
**G01R 19/165; H02J 7/00; H02J 7/34; H04R 1/10**

(86) International application number:
**PCT/KR2025/011740**

(87) International publication number:
**WO 2026/100901 (15.05.2026 Gazette 2026/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.11.2024 KR 20240156619**
**02.12.2024 KR 20240176929**

(71) Applicant: **Samsung Electronics Co., Ltd**
**Suwon-si, Gyeonggi-do 16677 (KR)**

(72) Inventor: **SER, Jiyeon**
**Suwon-si, Gyeonggi-do 16677 (KR)**

(74) Representative: **Appleyard Lees IP LLP**
**G Mill**
**Dean Clough Industrial Park**
**Halifax HX3 5AH (GB)**

(54) **CHARGING DEVICE AND METHOD FOR CHARGING WEARABLE DEVICE, AND NON-TRANSITORY COMPUTER-READABLE STORAGE MEDIUM**

(57)    A charging device includes a first interface, a second interface, memory storing instructions, at least one processor including processing circuitry. The instructions cause the charging device to obtain a first threshold charging level, obtain a second threshold charging level, wherein the second threshold charging level is greater than the first threshold charging level, identify a battery level of a first wearable device, based on identifying that the battery level of the first wearable device is less than the first threshold charging level, provide power to the first wearable device and provide power to a second wearable device, and based on identifying that the battery level is not less than the first threshold charging level, provide power only to the second wearable device.

FIG. 4

EP 4 787 663 A1

**Description**

**[Technical Field]**

The present disclosure relates to a charging device, a method, and a non-transitory computer readable storage medium for charging a wearable device.

**[Background Art]**

A wearable device may be worn on a user's body and operated. The wearable device may include a battery. The wearable device may provide a service without being connected to an external power source by using power supplied through the battery. It is desirable to improve the speed and efficiency of charging wearable devices, in particular, when a charging device is configured to charge multiple wearable devices, to improve the overall user experience.

The above-described information may be provided as a related art for the purpose of helping to understand the present disclosure. No claim or determination is raised as to whether any of the above-described information may be applied as a prior art related to the present disclosure.

**[Disclosure]**

**[Technical Solution]**

A charging device is provided. The charging device may comprise a first interface for connecting with a first wearable device. The charging device may comprise a second interface for connecting with a second wearable device. The charging device may comprise memory comprising one or more storage media storing instructions. The charging device may comprise at least one processor comprising processing circuitry. The instructions, when executed by the at least one processor individually or collectively, may cause the charging device to obtain a first threshold charging level corresponding to the first wearable device using the first interface. The instructions, when executed by the at least one processor individually or collectively, may cause the charging device to obtain a second threshold charging level corresponding to the second wearable device using the second interface. The instructions, when executed by the at least one processor individually or collectively, may cause the charging device to, based on identifying the second threshold charging level greater than the first threshold charging level, in accordance with a determination that a battery level of the first wearable device identified using the first interface is less than the first threshold charging level, provide power to the first wearable device via the first interface and provide power to the second wearable device via the second interface. The instructions, when executed by the at least one processor individually or collectively, may cause the charging device to, based on identifying the second threshold charging level greater than the first threshold charging level, in accordance with a determination that the battery level is not less than the first threshold charging level, provide power only to the second wearable device among the first wearable device and the second wearable device via the second interface.

A method is provided. The method may be performed by a charging device with a first interface for connecting with a first wearable device and a second interface for connecting with a second wearable device. The method may comprise obtaining a first threshold charging level corresponding to the first wearable device using the first interface. The method may comprise obtaining a second threshold charging level corresponding to the second wearable device using the second interface. The method may comprise, based on identifying the second threshold charging level greater than the first threshold charging level, in accordance with a determination that a battery level of the first wearable device identified using the first interface is less than the first threshold charging level, providing power to the first wearable device via the first interface and providing power to the second wearable device via the second interface. The method may comprise, based on identifying the second threshold charging level greater than the first threshold charging level, in accordance with a determination that the battery level is not less than the first threshold charging level, providing power only to the second wearable device among the first wearable device and the second wearable device via the second interface.

A non-transitory computer readable storage medium is provided. The non-transitory computer readable storage medium may store one or more programs. The one or more programs may comprise instructions to, when executed by a charging device with a first interface for connecting with a first wearable device and a second interface for connecting with a second wearable device, cause the charging device to obtain a first threshold charging level corresponding to the first wearable device using the first interface. The one or more programs may comprise instructions to, when executed by the charging device, cause the charging device to obtain a second threshold charging level corresponding to the second wearable device using the second interface. The one or more programs may comprise instructions to, when executed by the charging device, cause the charging device to, based on identifying the second threshold charging level greater than the first threshold charging level, in accordance with a determination that a battery level of the first wearable device identified using the first interface is less than the first threshold charging level, provide power to the first wearable device via the first interface and provide power to the second wearable device via the second interface. The one or more programs may comprise instructions to, when executed by the charging device, cause the charging device to, based on identifying the second threshold charging level greater than the first threshold charging level, in accordance with a determination that the battery level is not less than the first threshold charging level, provide power only to the second wearable device among the first wearable device and the second wearable device via the second interface.

A charging device is provided. The charging device may comprise a first interface for connecting with a first wearable device. The charging device may comprise a second interface for connecting with a second wearable device. The charging device may comprise memory comprising one or more storage media storing instructions. The charging device may comprise at least one processor comprising processing circuitry. The instructions, when executed by the at least one processor individually or collectively, may cause the charging device to obtain a first threshold charging level corresponding to the first wearable device using the first interface. The instructions, when executed by the at least one processor individually or collectively, may cause the charging device to obtain a second threshold charging level corresponding to the second wearable device using the second interface. The second threshold charging level is greater than the first threshold charging level. The instructions, when executed by the at least one processor individually or collectively, may cause the charging device to, identify a battery level of the first wearable device. The instructions, when executed by the at least one processor individually or collectively, may cause the charging device to, based on identifying that a battery level of the first wearable device is less than the first threshold charging level, provide power to the first wearable device via the first interface and provide power to the second wearable device via the second interface. The instructions, when executed by the at least one processor individually or collectively, may cause the charging device to, based on identifying that the battery level of the first wearable device is not less than the first threshold charging level, provide power only to the second wearable device.

A method is provided. The method may be performed by a charging device with a first interface for connecting with a first wearable device and a second interface for connecting with a second wearable device. The method may comprise obtaining a first threshold charging level corresponding to the first wearable device using the first interface. The method may comprise obtaining a second threshold charging level corresponding to the second wearable device using the second interface. The second threshold charging level is greater than the first threshold charging level. The method may comprise, identifying a battery level of the first wearable device. The method may comprise, based on identifying that a battery level of the first wearable device is less than the first threshold charging level, providing power to the first wearable device via the first interface and providing power to the second wearable device via the second interface. The method may comprise, based on identifying that the battery level of the first wearable device is not less than the first threshold charging level, providing power only to the second wearable device.

A non-transitory computer readable storage medium is provided. The non-transitory computer readable storage medium may store one or more programs. The one or more programs may comprise instructions to, when executed by a charging device with a first interface for connecting with a first wearable device and a second interface for connecting with a second wearable device, cause the charging device to obtain a first threshold charging level corresponding to the first wearable device using the first interface. The one or more programs may comprise instructions to, when executed by the charging device, cause the charging device to obtain a second threshold charging level corresponding to the second wearable device using the second interface. The second threshold charging level is greater than the first threshold charging level. The one or more programs may comprise instructions to, when executed by the charging device, cause the charging device to, identify a battery level of the first wearable device. The one or more programs may comprise instructions to, when executed by the charging device, cause the charging device to, based on identifying that a battery level of the first wearable device is less than the first threshold charging level, provide power to the first wearable device via the first interface and provide power to the second wearable device via the second interface. The one or more programs may comprise instructions to, when executed by the charging device, cause the charging device to, based on identifying that the battery level of the first wearable device is not less than the first threshold charging level, provide power only to the second wearable device.

**[Description of the Drawings]**

The subject-matter of the present disclosure is best understood with reference to the accompanying figures, in which:

FIG. 1 is a block diagram of an electronic device in a network environment;
FIG. 2 illustrates a simplified block diagram of an exemplary charging device;
FIG. 3 illustrates an example of a charging device connected to wearable devices;
FIG. 4 illustrates an example of operations of a charging device for providing power to wearable devices;
FIG. 5A illustrates an example of battery information received from a wearable device;

FIG. 5B illustrates an example of operations of a charging device for determining a threshold charging level;

FIG. 6 illustrates example graphs representing a state of a wearable device charged by a charging device;

FIG. 7 illustrates an example of operations of a charging device for charging wearable devices while obtaining external power;

FIG. 8 illustrates an example of operations of a charging device for charging wearable devices while not obtaining external power;

FIG. 9 illustrates an example of other operations of a charging device for charging wearable devices while not obtaining external power;

FIG. 10 illustrates an example of a charging device that is configured to provide power obtained from a first wearable device to a second wearable device; and

FIG. 11 illustrates an example of a first wearable device for charging wearable devices using a charging device.

[**Mode for Invention**]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

Terms referring to data (e.g. data, information, battery information), terms referring to values (e.g. reference time, reference charging level, threshold charging level, threshold state of charge (SOC)), terms for operational states (e.g. operation, process), terms referring to network entities, and terms referring to components of a device, which are used in the following description are exemplary terms, for convenience of explanation. Therefore, the present disclosure is not limited to the exemplary terms used below, and another term having an equivalent technical meaning may be used.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A to B' refers to at least one of elements from A (including A) to B (including B). Hereinafter, 'C and/or D' means including at least one of 'C' or 'D', that is, {'C', 'D', and 'C' and 'D'}.

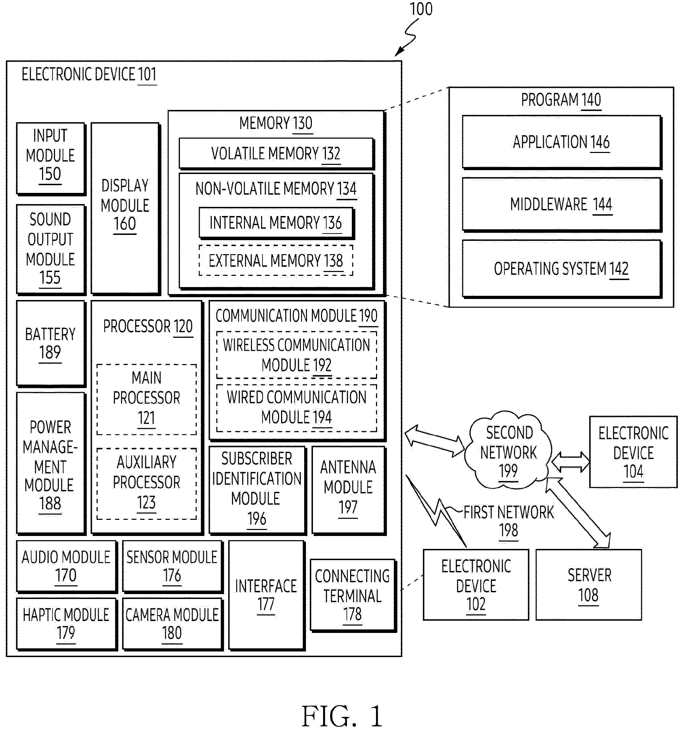

FIG. 1 is a block diagram illustrating an electronic device 101 in a network environment 100.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

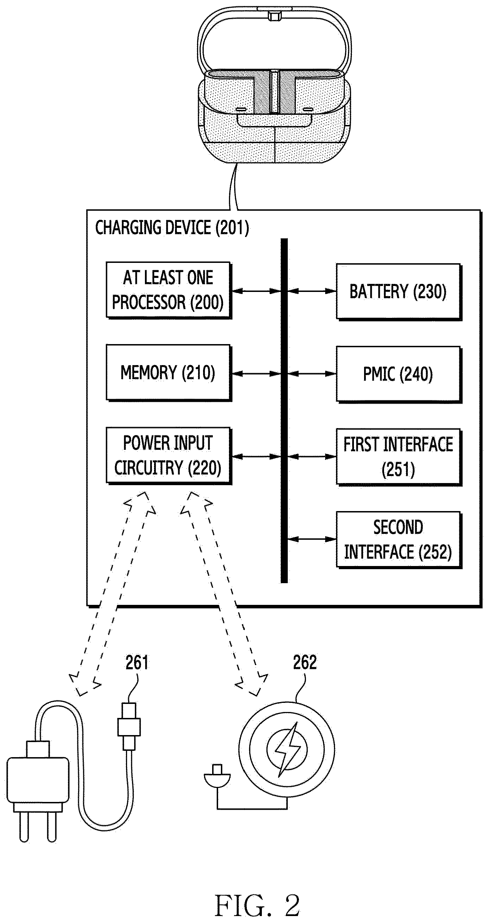

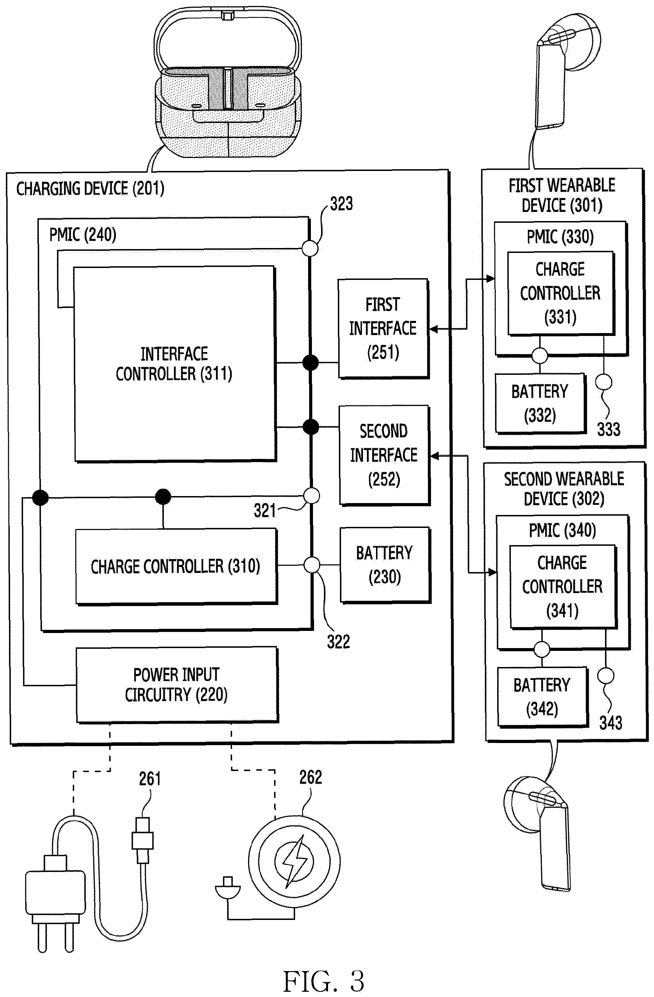

FIG. 2 illustrates a simplified block diagram of an exemplary charging device 201. For example, the charging device 201 may refer to an electronic device used to charge a wearable device (e.g., a first wearable device 301 and a second wearable device 302 of FIG. 3). The charging device 201 of FIG. 2 may be an example of the electronic device 101 of FIG. 1.

Referring to FIG. 2, the charging device 201 may include at least one processor 200, memory 210, power input circuitry 220, a battery 230, a power management integrated circuit (PMIC) 240, a first interface 251, and/or a second interface 252. For example, the at least one processor 200, the memory 210, the power input circuitry 220, the battery 230, the power management integrated circuit (PMIC) 240, the first interface 251, and/or the second interface 252 may be electronically and/or operably coupled with each other by a communication bus.

Herein, hardware components being operably coupled may mean that a direct or indirect connection between the hardware components is established by wire or wirelessly so that a second hardware component may be controlled by a first hardware component among the hardware components. The hardware components illustrated in FIG. 2 are illustrated in different blocks, but the present disclosure is not limited thereto. For example, a portion (e.g., the at least one processor 200, the memory 210, and the PMIC 240) of the hardware components illustrated in FIG. 2 may be included in a single integrated circuit such as a system on chip or a system in package (SIP). The type and/or number of hardware components included in the charging device 201 are not limited to those illustrated in FIG. 2. For example, the charging device 201 may include only a portion of the hardware components illustrated in FIG. 2.

The at least one processor 200 may include a hardware component for processing data based on executing instructions. The at least one processor 200 may be configured to individually or collectively execute instructions stored in the memory 210. The at least one processor 200 may include processing circuitry. For example, a hardware component for processing data may include an arithmetic and logic unit (ALU), a floating point unit (FPU), a field programmable gate array (FPGA). For example, a hardware component for processing data may include a central processing unit (CPU), a graphic processing unit (GPU), a display processing unit (DPU), a neural processing unit (NPU), a digital signal processor (DSP), an application processor (AP), and/or a microcontroller (MCU). The at least one processor 200 may include one or more cores. For example, the at least one processor 200 may have a multi-core processor structure such as a dual core, a quad core, or a hexa core. The description of the processor 120 of FIG. 1 may also be applied to the at least one processor 200 of FIG. 2. The at least one processor 200 may be configured to control the memory 210, the power input circuitry 220, the battery 230, the PMIC 240, the first interface 251, and/or the second interface 252.

The memory 210 may include a hardware component for storing data and/or instructions input to and/or output from the at least one processor 200. The memory 210 may include one or more storage media. For example, the memory 210 may include a volatile memory such as random-access memory (RAM) and/or a non-volatile memory such as read-only memory (ROM). For example, the volatile memory may include at least one of dynamic RAM (DRAM), static RAM (SRAM), cache RAM, or pseudo SRAM (PSRAM). For example, the non-volatile memory may include at least one of programmable ROM (PROM), erasable PROM (EPROM), electrically erasable PROM (EEPROM), flash memory, hard disk, compact disk, or embedded multimedia card (EMMC). The description of the memory 130 of FIG. 1 may be applied to the memory 210 of FIG. 2.

According to an embodiment, in the memory 210 of the charging device 201, one or more instructions (or commands) indicating a calculation and/or operation to be performed by the at least one processor 200 of the charging device 201 on data may be stored. A set of one or more instructions may be referred to as program, firmware, operating system, process, routine, subroutine and/or application. The charging device 201 exemplified in the description of FIG. 2 may be configured execute at least a portion of operations exemplified in descriptions of FIGS. 3 to 10. For example, the operations exemplified in the descriptions of FIGS. 3 to 10 may be caused by (or within) the charging device 201 under the control of the at least one processor 200.

The power input circuitry 220 may be used to obtain external power (or power). The charging device 201 may receive or obtain power for driving the charging device 201 and/or the at least one processor 200, when an external electronic device (e.g., a wired interface 261 and a wireless interface 262) is connected via the power input circuitry 220. The power input circuitry 220 may include at least a portion of the interface 177 of FIG. 1.

According to an embodiment, the power input circuitry 220 may include a universal serial bus (USB) port. For example, the charging device 201 may obtain, via the USB port, external power provided (or received, supplied, transferred, distributed, or applied) via the wired interface 261. For example, charging of the battery 230 (or the charging device 201) based on the wired interface 261 and the power input circuitry 220 (e.g., the USB port) may be referred to as wired charging or a wired charging method. For example, the wired interface 261 may include a travel adapter. For example, the wired interface 261 may be referred to as a wired charger.

According to an embodiment, the power input circuitry 220 may include an antenna for wireless inductive charging. For example, the charging device 201 may obtain, via the antenna, external power provided (or received, supplied, transferred, distributed, or applied) via the wireless interface 262. For example, charging of the battery 230 (or the charging device 201) based on the wireless interface 262 and the power input circuitry 220 (e.g., the antenna for wireless charging) may be referred to as wireless charging or a wireless charging method. For example, the wireless interface 262 may be referred to as a wireless charger. The antenna may be referred to as a wireless power consortium (WPC) antenna and/or a coil.

The battery 230 may be used to provide power for driving hardware components within the charging device 201. The battery 230 may store power (i.e. energy) provided from the outside of the charging device 201 via the power input circuitry 220. As a non-limiting example, the battery 230 may be used to provide power to a wearable device (e.g., the first wearable device 301 and the second wearable device 302 of FIG. 3). According to an embodiment, the battery 230 may include at least one cell. According to an embodiment, the battery 230 may be rechargeable. The description of the battery 189 of FIG. 1 may be applied to the battery 230 of FIG. 2.

The PMIC 240 may include a processor for managing power of the battery 230. The PMIC 240 may provide, transfer, distribute, apply, or supply power to other hardware components included in the charging device 201, based on the power provided to the PMIC 240. The PMIC 240 may control the battery 230 to store energy. Storing energy from an external power source within the battery 230 may be referred to as charging the battery 230 (or charging the charging device 201). The PMIC 240 may provide power (or a power signal) for driving hardware components. For example, the at least one processor 200 may operate based on the power received from the PMIC 240. According to an embodiment, external power provided via the power input circuitry 220 may be regulated by the PMIC 240 and then applied to hardware components.

According to an embodiment, the PMIC 240 may be used to provide power obtained from the battery 230 to the components (e.g., the at least one processor 200, the memory 210, the first interface 251, and/or the second interface 252) within the charging device 201, in accordance with the control of the at least one processor 200. In FIG. 2, the PMIC 240 and the at least one processor 200 are illustrated as separate hardware components, but the present disclosure is not limited thereto. For example, the PMIC 240 may be included within the at least one processor 200. The description of the power management module 188 of FIG. 1 may be applied to the PMIC 240.

The first interface 251 may include a connector (or a connection pin, or a connection terminal) capable of physically connecting the charging device 201 and an external electronic device (e.g., the first wearable device 301 and the second wearable device 302 of FIG. 3). For example, the first interface 251 may include an electrically conductive pin. For example, the first interface 251 may include a pogo pin. The description of the connection terminal 178 of FIG. 1 may be applied to the first interface 251.

The second interface 252 may correspond to or match the first interface 251. For example, the second interface 252 may form a pair with the first interface 251. For example, the second interface 252 may be substantially identical to the first interface 251. The description of the first interface 251 may be referenced for the second interface 252.

FIG. 3 illustrates an example of a charging device 201 connected to wearable devices (e.g., the first wearable device 301 and the second wearable device 302). In the present disclosure, providing power may include supplying power, transmitting power, and applying power. In addition, in the present disclosure, a battery level may be referred to as a charge amount of the battery, a state of charge (SOC) of the battery, a charging level of the battery and/or other terms with an equivalent technical meaning. In effect, the battery level refers to the current battery level, i.e., the battery level at a specific point in time.

Referring to FIG. 3, the charging device 201 of FIG. 3 may include the charging device 201 of FIG. 2. The charging device 201 may include power input circuitry 220, a PMIC 240, a battery 230, a first interface 251, and/or a second interface 252.

The charging device 201 may obtain external power via the power input circuitry 220. For example, the charging device 201 may obtain external power from a wired interface 261 via the power input circuitry 220. For example, the charging device 201 may obtain external power from a wireless interface 262 via the power input circuitry 220. The power input circuitry 220 may be configured to provide (or input) external power (or external voltage) to the PMIC 240. The power input circuitry 220 may be connected to the PMIC 240.

The PMIC 240 may obtain external power via the power input circuitry 220. The PMIC 240 may include a charge controller 310, an interface controller 311, a bypass terminal 321, a battery terminal 322, and/or an input terminal 323. The PMIC 240 may provide, to the charge controller 310, the external power obtained via the power input circuitry 220. The power input circuitry 220 may be connected to the charge controller 310.

The charge controller 310 may be used to control the battery 230 and manage a charging state of the battery 230. The charge controller 310 may prevent overcharging of the battery 230 and/or over-discharging of the battery 230 by controlling a battery level of the battery 230, a battery voltage of the battery 230, and/or a battery current of the battery 230. The charge controller 310 may stop charging of the battery 230, based on identifying an error related to charging of the battery 230. The charge controller 310 may be connected to the battery 230. The charging device 201 may charge the battery 230 using the charge controller 310 in the PMIC 240. The charge controller 310 may provide the obtained external power to the battery 230 via the battery terminal 322. The battery terminal 322 may be used to transmit power (or external power) between the charge controller 310 and the battery 230. The battery 230 may be charged with the provided external power.

The interface controller 311 may be an interface for providing (or transmitting) data (or electrical signals) to external electronic devices (e.g., the first wearable device 301 and the second wearable device 302) and/or providing power to the external electronic devices. The interface controller 311 may be connected to the first wearable device 301 via the first interface 251. The PMIC 240 may receive battery information of the first wearable device 301 via the first interface 251 by using the interface controller 311. The interface controller 311 may be connected to the second wearable device 302 via the second interface 252. The PMIC 240 may receive battery information of the second wearable device 302 via the second interface 252 by using the interface controller 311. The PMIC 240 may provide or transmit, to the first wearable device 301 via the first interface 251, information related to the charging device 201 by using the interface controller 311. The PMIC 240 may provide or transmit, to the second wearable device 302 via the second interface 252, information related to the charging device 201 by using the interface controller 311.

According to an embodiment, the PMIC 240 may provide, to the first wearable device 301 via the first interface 251, power obtained from the input terminal 323 by controlling the interface controller 311. The PMIC 240 may provide, to the second wearable device 302 via the second interface 251, power obtained from the input terminal 323 by controlling the interface controller 311. The input terminal 323 may be connected to the bypass terminal 321 and/or the battery 230. For example, the input terminal 323 may be connected to the bypass terminal 321 while the power input circuitry 220 obtains external power. As the input terminal 323 and the bypass terminal 321 are connected, the interface controller 311 may obtain external power from the power input circuitry 220. The PMIC 240 may provide or input, to the interface controller 311, external power obtained via the power input circuitry 220.

According to an embodiment, the PMIC 240 may provide the obtained external power to the bypass terminal 321. For example, the bypass terminal 321 may be connected to the power input circuitry 220. The bypass terminal 321 may be configured to provide the provided external power to the input terminal 323. For example, the bypass terminal 321 may be connected to the input terminal 323 in accordance with control of the PMIC 240 (or the at least one processor 200). For example, the PMIC 240 may provide external power to the input terminal 323 connected via the bypass terminal 321, by bypassing providing the obtained external power to the charge controller 310. The input terminal 323 may be configured to provide external power to the interface controller 311.

According to an embodiment, the charging device 201 (e.g., the at least one processor 200) may control the PMIC 240 to bypass providing external power to the charge controller 310, based on identifying that the first wearable device 301 is connected to the first interface 251 and/or the second wearable device 302 is connected to the second interface 252. The PMIC 240 may provide, to the bypass terminal 321, the external power obtained via the power input circuitry 220, by bypassing providing the external power to the charge controller 310. The PMIC 240 may provide external power to the interface controller 311 connected to the input terminal 323, by providing external power to the bypass terminal 321.

According to an embodiment, the input terminal 323 may be connected to the battery 230 while the power input circuitry 220 does not obtain external power. The interface controller 311 may be connected to the input terminal 323 and the battery 230 (or the battery terminal 322) to obtain power from the battery 230. The PMIC 240 may provide or input power to the interface controller 311 using the battery 230.

Each of the first wearable device 301 and the second wearable device 302 may be worn on a user's body part. For example, the body part may include a user's ear part or an ear canal part of the ear. For example, the first wearable device 301 may be worn on the user's ear, and the second wearable device 301 may be worn on the user's other ear. For example, the first wearable device 301 and the second wearable device 302 may be referred to as earbuds, earphones, and/or headsets. Each of the first wearable device 301 and the second wearable device 302 may be an example of the electronic device 101 of FIG. 1.

The first wearable device 301 and the second wearable device 302 may be formed of a pair of wearables. At least a portion of hardware components of the first wearable device 301 may be substantially the same as at least a portion of hardware components of the second wearable device 302. Herein, the description of the first wearable device 301 can be applied to the second wearable device 302, and overlapping or redundant description may be omitted to reduce repetition.

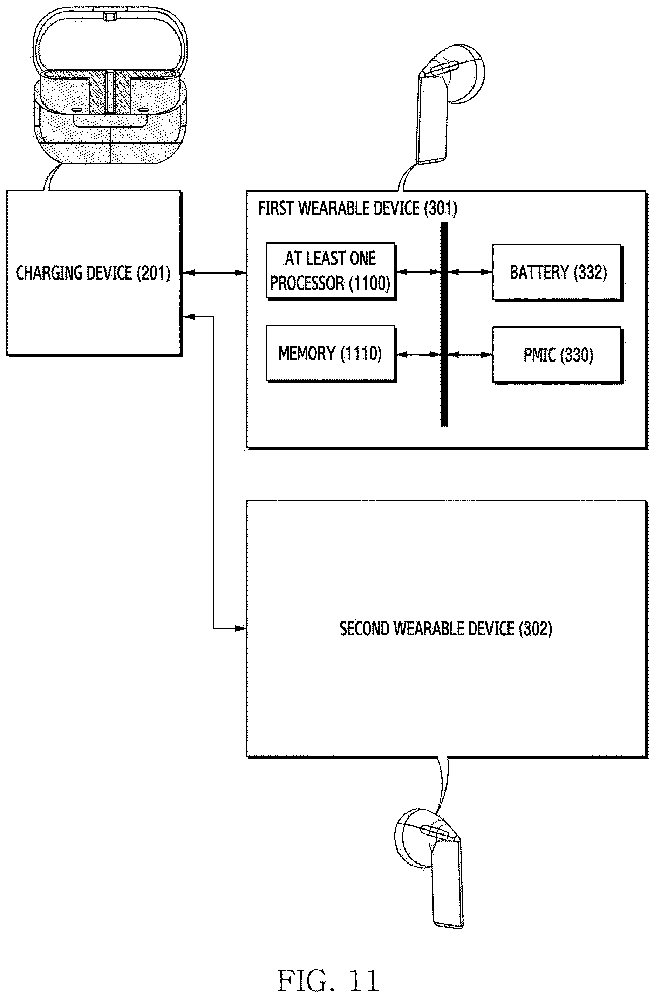

The first wearable device 301 may include a PMIC 330, a battery 332, and/or a system input terminal 333. The PMIC 330 may include a charge controller 331. The PMIC 330 may be a processor for managing power of the battery 332. The PMIC 330 may be used to provide power obtained from the charging device 201 to each of components in the first wearable device 301, in accordance with control of a processor (e.g., at least one processor 1100 of FIG. 11) of the first wearable device 301. As a non-limiting example, the PMIC 330 may be used to provide power obtained from the battery 332 to each of components in the first wearable device 301, in accordance with control of a processor (e.g., at least one processor 1100 of FIG. 11) of the first wearable device 301. The PMIC 330 may be connected to the system input terminal 333. The system input terminal 333 may be connected to hardware components of the first wearable device 301. The PMIC 330 may be used to provide power to each of the components in the first wearable device 301, by providing power (or voltage) to the system input terminal 333. The PMIC 330 may be equivalent to or substantially the same as the PMIC 240 of FIG. 2 and/or 3. The descriptions of the PMIC 240 of FIG. 2 and/or 3 may be referenced for the PMIC 330.

The charge controller 331 may be used to control the battery 332 and manage a charging state of the battery 332. The charge controller 331 may prevent overcharging of the battery 332 and/or over-discharging of the battery 332 by controlling charging and/or discharging of the battery 332. The charge controller 331 may stop charging the battery 332 based on identifying an error related to charging of the battery 332. The charge controller 331 may be connected to the battery 332. The first wearable device 301 may charge the battery 332 using the charge controller 331 in the PMIC 330. The charge controller 331 may be equivalent to or substantially the same as the charge controller 310 of the charging device 201.

The battery 332 may be used to provide power for driving hardware components in the first wearable device 301. The first wearable device 301 may obtain power (or voltage) from the charging device 201. The first wearable device 301 may store power obtained using the PMIC 330 in the battery 332. The battery 332 may be rechargeable. The description of the battery 189 of FIG. 1 may be applied to the battery 332.

The second wearable device 302 may include a PMIC 340, a battery 342, and/or a system input terminal 343. The PMIC 340 may be equivalent to or substantially the same as the PMIC 330 of the first wearable device 301. The descriptions of the PMIC 330 may be referenced for the PMIC 340. The battery 342 may be equivalent to or substantially the same as the battery 332 of the first wearable device 301. The descriptions of the battery 332 may be referenced for the battery 342. The system input terminal 343 may be equivalent to or substantially the same as the system input terminal 333 of the first wearable device 301. The descriptions of the system input terminal 333 may be referenced for the system input terminal 343.

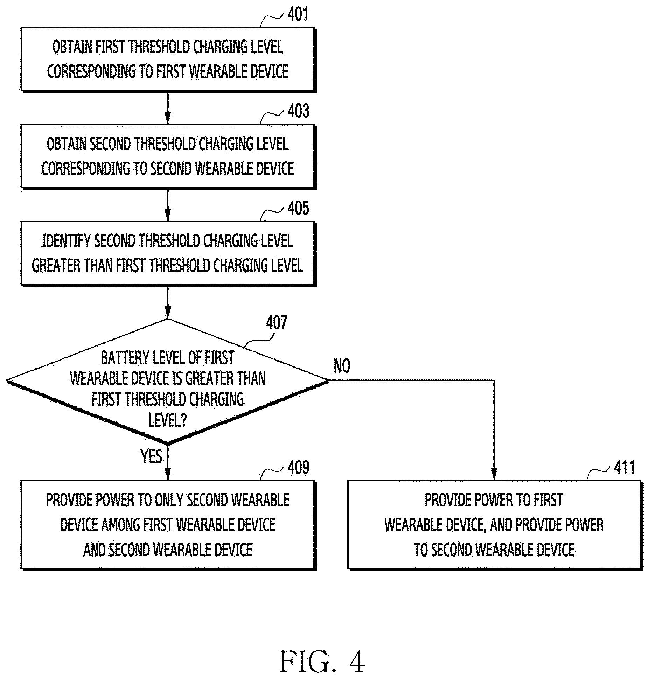

In the present disclosure, one of the first wearable device 301 and the second wearable device 302 with a relatively high frequency of use may be determined to be a primary device, and one of the first wearable device 301 and the second wearable device 302 with a relatively low frequency may be determined to be a secondary device. For example, the first wearable device 301 may be determined to be the secondary device, and the second wearable device 302 may be determined to be the primary device. The charging device 201 or another device may perform the determination. The charging device 201 may execute a method of charging the second wearable device 302 determined as the primary device prior to the first wearable device 301 determined as the secondary device. The charging device 201 may execute a method of charging the second wearable device 302 determined as the primary device faster than the first wearable device 301 determined as the secondary device. This method will be described and exemplified in FIGS. 4, 5A, 5B, 6, 7, 8, 9, 10, and/or 11.

FIG. 4 illustrates an example of operations of a charging device (e.g., the charging device 201) for providing power to wearable devices (e.g., the first wearable device 301 and the second wearable device 302). Providing power may include supplying power, transmitting power, and/or applying power. In addition, in the present disclosure, a battery level may be referred to as a charge amount of battery, a state of charge (SOC) of battery, and/or other terms with an equivalent technical meaning.

Referring to FIG. 4, in operation 401, the charging device 201 (e.g., the at least one processor 200) may obtain, determine, or identify a first threshold charging level corresponding to the first wearable device 301 using a first interface (e.g., the first interface 251). The first threshold charging level may be described as a battery level targeted by the charging device 201 by charging a battery (e.g., the battery 332) of the first wearable device 301. For example, the charging device 201 may target the first threshold charging level by providing power to the first wearable device 301 until the battery level of the battery 332 reaches the first threshold charging level.

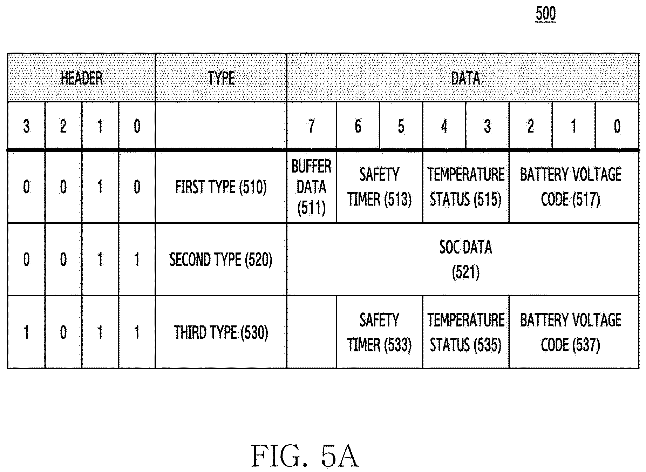

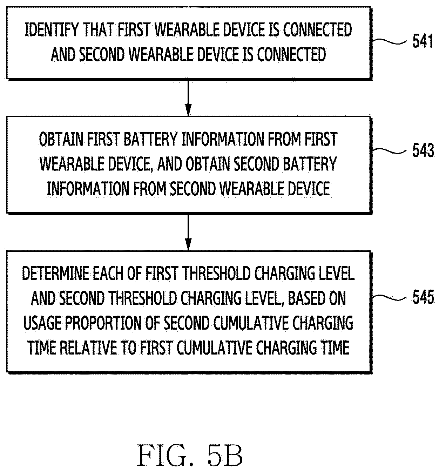

The charging device 201 may be connected to the first wearable device 301 via the first interface 251. While connected to the first wearable device 301, the charging device 201 may obtain first battery information from the first wearable device 301. While connected to the first wearable device 301, the charging device 201 may periodically obtain the first battery information. Based on the obtained first battery information, the charging device 201 may obtain, determine, or identify the first threshold charging level. The first battery information may indicate information (e.g., battery level) related to a battery (e.g., the battery 332) of the first wearable device 301. The charging device 201 may store charging time of the first wearable device 301. The charging device 201 may store time for providing power to the first wearable device 301 via the first interface 251. The charging device 201 may store time until the battery 332 of the first wearable device 301 is fully charged, by providing power to the first wearable device 301. The charging device 201 may obtain, determine, or identify first cumulative charging time using the stored time. The charging device 201 may determine the first threshold charging level to be greater when the first cumulative charging time is longer. In effect, the first threshold charging level may be changed according to the first cumulative charging time. For example, the charging device 201 may determine or obtain the first threshold charging level, based on a time interval during which power is provided to the first wearable device 301 via the first interface 251. The obtaining of the first threshold charging level by the charging device 201 will be described and exemplified with reference to FIGS. 5A and 5B.

In operation 403, the charging device 201 (e.g., the at least one processor 200) may obtain, determine, or identify a second threshold charging level corresponding to the second wearable device 302 using a second interface (e.g., the second interface 252). The second threshold charging level may be described as a battery level targeted by the charging device 201 by charging a battery (e.g., the battery 342) of the second wearable device 302. For example, the charging device 201 may target the second threshold charging level by providing power to the second wearable device 302 until the battery level of the battery 342 reaches the second threshold charging level.

The charging device 201 may be connected to the second wearable device 302 via the second interface 252. While connected to the second wearable device 302, the charging device 201 may obtain second battery information from the second wearable device 302. While connected to the second wearable device 302, the charging device 201 may periodically obtain the second battery information. The charging device 201 may obtain, determine, or identify a second threshold charging level, based on the obtained second battery information. The second battery information may indicate information (e.g., battery level) related to a battery (e.g., the battery 342) of the second wearable device 302. The charging device 201 may store charging time of the second wearable device 302. The charging device 201 may store time for providing power to the second wearable device 302 via the second interface 252. The charging device 201 may store time until the battery 342 of the second wearable device 302 is fully charged, by providing power to the second wearable device 302. The charging device 201 may obtain, determine, or identify second cumulative charging time by using the stored time. The charging device 201 may determine the second threshold charging level to be greater when the second cumulative charging time is longer. In effect, the second threshold charging level may be changed according to the second cumulative charging time. For example, the charging device 201 may determine or obtain the second threshold charging level, based on the time interval during which power is provided to the second wearable device 302 via the second interface 252. The obtaining of the second threshold charging level by the charging device 201 will be described and exemplified with reference to FIGS. 5A and 5B.

In operation 405, the charging device 201 (e.g., the at least one processor 200) may compare the first threshold charging level and the second threshold charging level. For example, the charging device 201 may identify the second threshold charging level as the charging level that is the greater of the two charging levels. For example, in response to identifying the second threshold charging level, the charging device 201 may determine the first wearable device 301 as a secondary device and the second wearable device 302 as a primary device. The second charging level being greater than the first charging level indicates that the frequency of use of the second wearable device 302 determined to be the primary device is higher than the frequency of use of the first wearable device 301 determined to be the secondary device.

In operation 407, the charging device 201 (e.g., the at least one processor 200) may identify whether the battery level of the first wearable device 301 is greater than the first threshold charging level. The battery level of the first wearable device 301 may indicate a charge amount of the battery 332 of the first wearable device 301. The battery level of the first wearable device 301 may correspond to a state of charge (SOC) of the battery 332. The charging device 201 may identify the battery level based on the battery information. Identifying of the battery level by the charging device 201 based on the battery information will be described and exemplified in detail with reference to FIGS. 5A and 5B. The charging device 201 may execute operation 409, in accordance with a determination that the battery level of the first wearable device 301 is greater than the first threshold charging level (or is not less than the first threshold charging level, or is not lower than the first threshold charging level). The charging device 201 may execute operation 411, in accordance with a determination that the battery level of the first wearable device 301 is not greater than the first threshold charging level (or is less than the first threshold charging level, or is lower than the first threshold charging level).

According to an embodiment, in operation 407, comparing the battery level of the first wearable device 301 with the first threshold charging level may comprise comparing a battery voltage of the battery 332 of the first wearable device 301 with a first threshold battery voltage. The first threshold battery voltage may correspond to the first threshold charging level. According to an embodiment, in operation 407, comparing the battery level of the first wearable device 301 with the first threshold charging level may comprise comparing a SOC of the battery 332 of the first wearable device 301 with a first threshold SOC. The first threshold SOC may correspond to the first threshold charging level. The first threshold SOC may be described as the SOC of the battery 332 targeted by the charging device 201 by charging the battery 332 of the first wearable device 301.

In operation 409, the charging device 201 (e.g., the at least one processor 200) may provide power to only the second wearable device 302 among the first wearable device 301 and the second wearable device 302 via the second interface 252, in accordance with a determination that the battery level of the first wearable device 301 is greater than the first threshold charging level (or is not less than the first threshold charging level, or is not lower than the first threshold charging level). For example, the charging device 201 may charge only the second wearable device 302 among the first wearable device 301 and the second wearable device 302. For example, the charging device 201 may connect electrically only the second wearable device 302 among the first wearable device 301 and the second wearable device 302 to power input circuitry (e.g., the power input circuitry 220). For example, the charging device 201 may connect the second wearable device 302 and the power input circuitry 220, instead of connecting the first wearable device 301 and the power input circuitry 220. For example, the charging device 201 may disconnect the first wearable device 301 and the power input circuitry 220, and connect the second wearable device 302 and the power input circuitry 220 via the second interface 252. For example, the charging device 201 may establish a charging connection between the second wearable device 302 and the power input circuitry 220 without a charging connection between the first wearable device 301 and the power input circuitry 220. For example, the charging device 201 may refrain from or block providing power to the first wearable device 301, and provide power to the second wearable device 302 via the second interface 252. In this way, the amount of power provided to the second wearable device 302 can be increased because power is not provided to the first wearable device 301. In effect, the amount of power that is provided to the second wearable device 302 in operation 409 is greater than the amount (or magnitude) of power provided to the second wearable device 202 in operation 411 described later. This may also increase a charging speed of the second wearable device 202 in operation 409. In effect, the charging speed of the second wearable device 202 is faster than a charging speed of the second wearable device 302 in operation 411 described later.

According to an embodiment, the charging device 201 may increase the amount (or magnitude) of power to be provided to the second wearable device 302 by bypassing providing power to the first wearable device 301In this way, the amount (or magnitude) of power provided to the second wearable device 202 in operation 409 is greater than the amount (or magnitude) of power provided to the second wearable device 202 in operation 411 described later. For example, the charging device 201 may provide external power (e.g., obtained via the power input circuitry 220) provided to an interface controller (e.g., the interface controller 311) to only the second wearable device 302 via the second interface 252.

In operation 411, the charging device 201 (e.g., the at least one processor 200) may provide power to the first wearable device 301 via the first interface 251, and provide power to the second wearable device 302 via the second interface 252, in accordance with a determination that the battery level of the first wearable device 301 is not greater than the first threshold charging level (or is less than the first threshold charging level, or is lower than the first threshold charging level). In this way, the charging device 201 may charge the first wearable device 301 and the second wearable device 302. For example, the charging device 201 may connect the first wearable device 301 and the power input circuitry 220 via the first interface 251 and connect the second wearable device 302 and the power input circuitry 220 via the second interface 252. For example, the charging device 201 may provide power to the first wearable device 301 via the first interface 251 and to the second wearable device 302 via the second interface 252.

According to an embodiment, the amount (or magnitude) of power provided to the second wearable device 202 in operation 411 is less than the amount (or magnitude) of power provided to the second wearable device 202 in operation 409. The charging device 201 may distribute external power (e.g., obtained via the power input circuitry 220) provided to an interface controller (e.g., the interface controller 311) to the first wearable device 301 and the second wearable device 302.

According to an embodiment, the charging device 201 may charge the second wearable device 302 determined as the primary device prior to charging the first wearable device 301 determined as the secondary device, by executing the operations of FIG. 4. The frequency of use of the primary device is greater than a frequency of use of the secondary device. By charging the second wearable device 302 determined as the primary device prior to the first wearable device 301 determined as the secondary device, a charged (i.e., available) time of the wearable device 301 perceived by the user may increase. This is because the more frequently used device (i.e., the second wearable device 302) is charged to the second threshold charging level faster, and before the less frequently used device (i.e., the first wearable device 301) begins charging. The charging device 201 may provide an enhanced user experience.

FIG. 5A illustrates an example of battery information 500 (e.g., the first battery information, the second battery information of FIG. 3) received from a wearable device (e.g., the first wearable device 301, the second wearable device 302). A charging device (e.g., the charging device 201) may obtain battery information 500 from a wearable device (e.g., the first wearable device 301, the second wearable device 302) via an interface (e.g., the first interface 251, the second interface 252). According to an embodiment, the charging device 201 may obtain the battery information 500 using a power line communication (PLC) technology. For example, the PLC may be described as a communication technology that transmits data via a power line. For example, the battery information 500 may be in a PLC packet and may be obtained therefrom.

Referring to FIG. 5A, the battery information 500 may include information of a first type 510, information of a second type 520, and/or information of a third type 530.

According to an embodiment, the information of the first type 510 may include a header. The header may comprise 4-bit data. For example, a header of the information of the first type 510 may comprise binary number '0010'. For example, a header of the information of the first type 510 may comprise hexadecimal number '0x2'. A wearable device (e.g., the first wearable device 301, the second wearable device 302) may provide, transmit, or transfer the information of the first type 510 to the charging device 201, in response to identifying that it is connected to the charging device 201. The charging device 201 may obtain or receive the information of the first type 510 via an interface (e.g., the first interface 251, the second interface 252). The information of the first type 510 may include data indicating a state of the wearable device. The state of the wearable device may include a state of a battery (e.g., the battery 332, the battery 342) of the wearable device. For example, the information of the first type 510 may include buffer data 511, a safety timer 513, a temperature status 515, and/or a battery voltage code 517. The buffer data 511 may indicate whether a battery (e.g., the battery 332, the battery 342) of a wearable device is fully charged. The buffer data 511 may comprise 1-bit data. The buffer data 511 may be referred to as 'SOC 100'. The safety timer 513 may indicate whether a safety function is being executed in the wearable device. The safety function may be described as a function of stopping (or terminating) charging of a battery (e.g., the battery 332, the battery 342) of the wearable device when the battery is not fully charged even after a reference time has passed since charging of the battery has started. The safety timer 513 may comprise 2-bit data. The temperature status 515 may indicate a temperature of a battery (e.g., the battery 332, the battery 342) of the wearable device. The temperature status 515 may include magnitude of a voltage corresponding to the temperature of the battery. For example, a wearable device (e.g., the first wearable device 301, the second wearable device 302) may measure a voltage corresponding to a temperature of a battery (e.g., the battery 332, the battery 342) using a PMIC (e.g., the PMIC 330, the PMIC 340). The measured voltage may be included in the temperature status 515. The temperature status 515 may comprise 2-bit data. The battery voltage code 517 may indicate a voltage (or battery voltage) of a battery (e.g., the battery 332, the battery 342) of the wearable device. The battery voltage code 517 may comprise 3-bit data. Using a voltage of a battery (e.g., the battery 332, the battery 342) indicated by the battery voltage code 517, a battery level of a wearable device (e.g., the first wearable device 301, the second wearable device 302) may be identified or determined.

According to an embodiment, the information of the second type 520 may include a header. The header may comprise 4-bit data. For example, the header of the information of the second type 520 may comprise binary number '0011'. For example, the header of the information of the second type 520 may comprise hexadecimal number '0x3'. A wearable device (e.g., the first wearable device 301, the second wearable device 302) may provide, transmit, or transfer the information of the second type 520 to the charging device 201. The charging device 201 may obtain or receive the information of the second type 520 via an interface (e.g., the first interface 251, the second interface 252). The information of the second type 520 may include SOC data 521. The SOC data 521 may indicate SOC of a battery (e.g., the battery 332, the battery 342) of the wearable device. The SOC data 521 may comprise 8-bit data.

According to an embodiment, the information of the third type 530 may include a header. The header may comprise 4-bit data. For example, the header of the information of the third type 530 may comprise binary number '1011'. For example, the header of the information of the third type 530 may comprise hexadecimal number '0xB'. A wearable device (e.g., the first wearable device 301, the second wearable device 302) may provide, transmit, or transfer the information of the third type 530 to the charging device 201, in response to identifying that a state (e.g., battery voltage, battery level, the SOC) of the battery has changed. The charging device 201 may obtain or receive the information of the third type 530 via an interface (e.g., the first interface 251, the second interface 252). The information of the third type 530 may include data indicating the state of the wearable device. The state of the wearable device may include a state of a battery (e.g., the battery 332, the battery 342) of the wearable device. For example, the information of the third type 530 may include a safety timer 533, a temperature status 535, and/or a battery voltage code 537. The safety timer 533 may be substantially the same as the safety timer 513, and thus, a redundant description thereof will be omitted. The temperature status 535 may be substantially the same as the temperature status 515, and thus, a redundant description thereof will be omitted. The battery voltage code 537 may be substantially the same as the battery voltage code 517, and thus, a redundant description thereof will be omitted.

FIG. 5B illustrates an example of operations of a charging device (e.g., the charging device 201) for determining a threshold charging level (e.g., the first threshold charging level, the second threshold charging level of FIG. 4). The operations (e.g., operations 541, 543, and 545) of FIG. 5B may be related to the operations 401 and/or 403 of FIG. 4.

Referring to FIG. 5B, in operation 541, the charging device 201 (e.g., the at least one processor 200) may identify that a first wearable device (e.g., the first wearable device 301) is connected to the charging device 201 and a second wearable device (e.g., the second wearable device 302) is connected to the charging device 201. The charging device 201 may be connected to the first wearable device 301 via a first interface (e.g., the first interface 251). The charging device 201 may be connected to the second wearable device 302 via a second interface (e.g., the second interface 251).

According to an embodiment, the charging device 201 may initiate charging of the first wearable device 301 in response to identifying that the first wearable device 301 is connected. Charging the first wearable device 301 by the charging device 201 may include providing power to the first wearable device 301. While charging the first wearable device 301, the charging device 201 may measure first charging time and store the first charging time. The first charging time may include time during which a battery (e.g., the battery 332) of the first wearable device 301 is charged, e.g., time until the battery is fully charged. The charging device 201 may obtain, determine, or calculate first cumulative charging time based on the first charging time. For example, the charging device 201 may obtain the first cumulative charging time by cumulatively summing the first charging time obtained over a period of time, e.g., hours, days, weeks, etc. For example, the first charging time may be obtained in an active state (e.g., including a standby state and a charging state, excluding a discharging state). For example, the charging device 201 may obtain the first cumulative charging time by cumulatively summing the first charging time obtained during a reference time (e.g., 10 hours).

According to an embodiment, the charging device 201 may initiate charging of the second wearable device 302 in response to identifying that the second wearable device 302 is connected. Charging the second wearable device 302 by the charging device 201 may include providing power to the second wearable device 302. While charging the second wearable device 302, the charging device 201 may measure second charging time and store the second charging time. The second charging time may include time during which a battery (e.g., the battery 332) of the second wearable device 302 is charged, e.g., time until the battery is fully charged. The charging device 201 may obtain, determine, or calculate second cumulative charging time based on the second charging time. For example, the charging device 201 may obtain the second cumulative charging time by cumulatively summing the second charging time obtained over a period of time, e.g., hours, days, weeks, etc. For example, the second charging time may be obtained in an active state (e.g., including a standby state and a charging state, excluding a discharging state). For example, the charging device 201 may obtain the second cumulative charging time by cumulatively summing the second charging time obtained during a reference time (e.g., 10 hours).

According to an embodiment, the charging device 201 may periodically obtain the first cumulative charging time and/or the second cumulative charging time. For example, the charging device 201 may repeatedly calculate or determine the first cumulative charging time and/or the second cumulative charging time every designated time period (e.g., 5 hours).

In operation 543, the charging device 201 (e.g., the at least one processor 200) may obtain first battery information (e.g., the battery information 500) from the first wearable device 301, and may obtain second battery information (e.g., the battery information 500) from the second wearable device 302.

According to an embodiment, the charging device 201 may obtain or identify a battery level (or SOC of the battery 332) of the first wearable device 301 using the first battery information. The charging device 201 may identify whether the first wearable device 301 is fully charged, by using the battery level (or the SOC of the battery 332) of the first wearable device 301. For example, the charging device 201 may identify whether a battery level (or battery voltage) has reached a full-charge level (or a full-charge voltage) and/or whether a value indicated by the SOC of the battery 332 is 'about 100%'. For example, the charging device 201 may identify that the battery level (or the SOC of the battery 332) of the first wearable device 301 increases, by using the first battery information. The charging device 201 may initiate measurement of the first charging time, in response to identifying that the battery level (or the SOC of the battery 332) of the first wearable device 301 increases. The charging device 201 may terminate the measurement of the first charging time, in response to identifying that the battery level of the first wearable device 301 has reached the full-charge level. As a non-limiting example, the charging device 201 may terminate the measurement of the first charging time, in response to identifying that the value of the SOC of the battery 332 of the first wearable device 301 indicates 'about 100%'. The charging device 201 may exclude, from the first charging time, time during which recharging is performed to maintain the first wearable device 301 in a fully charged state after the first wearable device 301 is fully charged.

According to an embodiment, the charging device 201 may obtain or identify a battery level (or SOC of the battery 342) of the second wearable device 302 by using the second battery information. The charging device 201 may identify whether the second wearable device 302 is fully charged, by using the battery level (or the SOC of the battery 342) of the second wearable device 302. For example, the charging device 201 may identify whether the battery level (or the battery voltage) has reached a full-charge level (or a full-charge voltage) and/or whether a value indicated by the SOC of the battery 342 is 'about 100%'. For example, the charging device 201 may identify that the battery level (or the SOC of the battery 342) of the second wearable device 302 increases, by using the second battery information. The charging device 201 may initiate measurement of the second charging time, in response to identifying that the battery level (or the SOC of the battery 342) of the second wearable device 302 increases. The charging device 201 may terminate the measurement of the second charging time, in response to identifying that the battery level of the second wearable device 302 has reached the full-charge level. As a non-limiting example, the charging device 201 may terminate the measurement of the second charging time, in response to identifying that the value of the SOC of the battery 342 of the second wearable device 302 indicates 'about 100%'. The charging device 201 may exclude, from the second charging time, time during which recharging is performed to maintain the second wearable device 302 in a fully charged state after the second wearable device 302 is fully charged.

In operation 545, the charging device 201 (e.g., the at least one processor 200) may determine the first threshold charging level and the second threshold charging level, respectively, based on a usage proportion, i.e., a ratio, of the second cumulative charging time relative to the first cumulative charging time. For example, as the usage proportion, i.e., ratio, of the second cumulative charging time relative to the first cumulative charging time becomes larger, the charging device 201 may determine the first threshold charging level to be smaller and the second threshold charging level to be larger.

According to an embodiment, the charging device 201 may obtain, determine, or calculate each of a first usage proportion of the first wearable device 301 and a second usage proportion of the second wearable device 302, in accordance with a ratio of the second cumulative charging time to the first cumulative charging time. The following equation may be referred to as a method of calculating each of the first usage and the second usage.

[Equation 1]

$$U_L = \frac{Ct_L}{Ct_L + Ct_R}$$

$U_L$ indicates a first usage proportion. $Ct_L$ indicates the first cumulative charging time. A unit of $Ct_L$ may be minutes. $Ct_R$ indicates the second cumulative charging time. A unit of $Ct_R$ may be minutes.

[Equation 2]

$$U_R = \frac{Ct_R}{Ct_L + Ct_R}$$

$U_R$ indicates a second usage proportion. $Ct_L$ indicates the first cumulative charging time. A unit of $Ct_L$ may be minutes. $Ct_R$ indicates the second cumulative charging time. A unit of $Ct_R$ may be minutes.

According to an embodiment, the charging device 201 may obtain, determine, or calculate a first threshold SOC, in accordance with the first usage proportion obtained using [Equation 1]. The first threshold SOC may correspond to the first threshold charging level. The first threshold SOC may be described as the SOC of the battery 332 targeted by the charging device 201 by charging the battery 332 of the first wearable device 301. When the SOC of the battery 332 is the first threshold charging level, the battery level of the battery 332 may be the first threshold charging level. The charging device 201 may obtain, determine, or calculate a second threshold SOC, in accordance with the second usage obtained using [Equation 2]. The second threshold SOC may correspond to the second threshold charging level. The second threshold SOC may be described as the SOC of the battery 342 targeted by the charging device 201 by charging the battery 342 of the second wearable device 302. When the SOC of the battery 342 is the second threshold charging level, the battery level of the battery 342 may be the second threshold charging level. Each of the first threshold SOC and the second threshold SOC may be calculated by the following equation.

[Equation 3]

$$CHG\_th_L = U_L \times 100 \ (CHG\_th_L = 20 \ if \ CHG\_th_L < 20)$$

$CHG\_th_L$ indicates the first threshold SOC. A unit of $CHG\_th_L$ may be percent (%). The first threshold SOC may be greater than a specified value (e.g. 20%, as shown as an example in [Equation 3]). The specified value may be set in the charging device 201. The specified value may be set by the user.

[Equation 4]

$$CHG\_th_R = U_R \times 100 \ (CHG\_th_R = 20 \ if \ CHG\_th_R < 20)$$

$CHG\_th_R$ indicates the second threshold SOC. A unit of $CHG\_th_R$ may be percent (%). The second threshold SOC may be greater than a specified value (e.g., 20%, as shown as an example in [Equation 4]). The specified value may be set in the charging device 201. The specified value may be set by the user.

According to an embodiment, the charging device 201 may obtain the first threshold charging level in accordance with the first threshold SOC obtained using [Equation 3]. The charging device 201 may obtain the second threshold charging level in accordance with the second threshold SOC obtained using [Equation 4].

According to an embodiment, the charging device 201 may determine a primary device and a secondary device, by comparing the first usage proportion of the first wearable device 301 and the second usage proportion of the second wearable device 302. For example, the charging device 201 may determine the first wearable device 301 as the secondary device and the second wearable device 301 as the primary device, in accordance with a determination that the second usage proportion is greater than the first usage proportion.

According to an embodiment, the charging device 201 may determine a primary device and a secondary device by comparing the first threshold charging level (or the first threshold SOC) of the first wearable device 301 and the second threshold charging level (or the second threshold SOC) of the second wearable device 302. For example, the charging device 201 may determine the first wearable device 301 as the secondary device and the second wearable device 301 as the primary device, in accordance with a determination that the second threshold charging level (or the second threshold SOC) is greater than the first threshold charging level (or the first threshold SOC).

The method of calculating the first usage proportion, the method of calculating the second usage proportion, the method of calculating the first threshold charging level, and/or the method of calculating the second threshold charging level illustrated in FIG. 5B are merely exemplary for convenience of description, and embodiments of the present disclosure are not limited thereto.

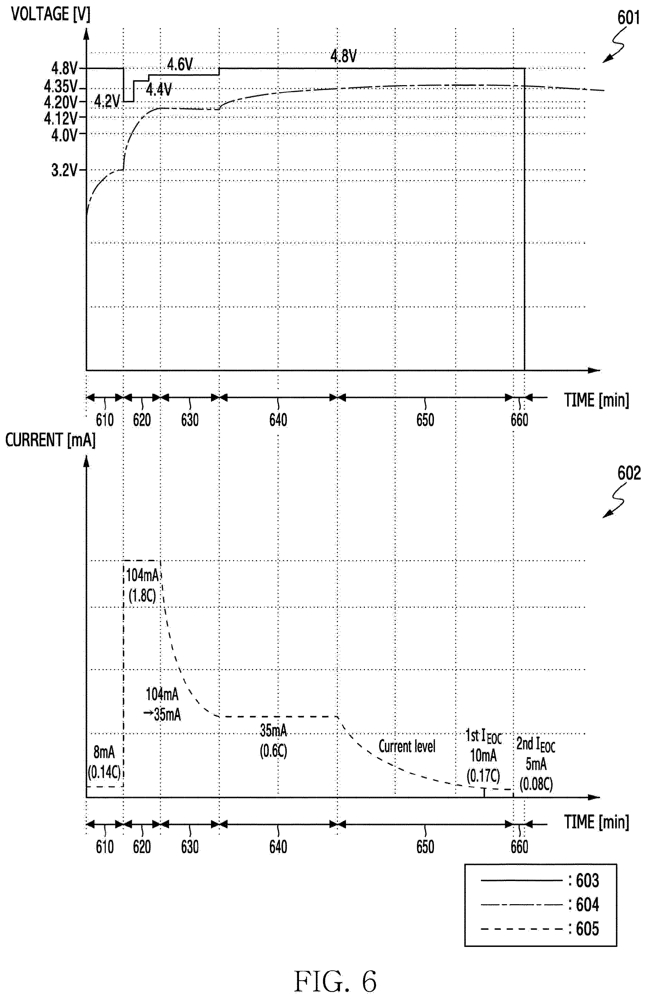

FIG. 6 illustrates an example of a graph representing a state of a wearable device (e.g., the first wearable device 301, the second wearable device 302) charged by a charging device (e.g., the charging device 201). The wearable device (e.g., the first wearable device 301, the second wearable device 302) may obtain power from the charging device 201.

The wearable device may be connected to the charging device 201 via an interface (e.g., the first interface 251, the second interface 252). For example, the wearable device may be connected to a battery (e.g., the battery 230) within the charging device 201. For example, the wearable device may be connected to power input circuitry (e.g., the power input circuitry 220) within the charging device 201.

Referring to FIG. 6, the graph 601 may represent a state of voltage obtained by a wearable device (e.g., the first wearable device 301, the second wearable device 302) over time and a state of battery voltage of a battery (e.g., the battery 332, the battery 342) of the wearable device over time, while the wearable device is charged. A horizontal axis of the graph 601 may indicate time. A unit of the horizontal axis of the graph 601 may be minutes. A vertical axis of the graph 601 may indicate voltage. A unit of the vertical axis of the graph 601 may be volts (V).

According to an embodiment, a line 603 may indicate a voltage obtained by the wearable device. For example, the line 603 may be referenced as a voltage provided to the wearable device by the charging device 201 via an interface (e.g., the first interface 251, the second interface 252).

According to an embodiment, a line 604 may indicate the battery voltage of the battery of the wearable device.

According to an embodiment, a graph 602 may represent a state of current over time. The graph 602 may represent a state of current obtained by a wearable device (e.g., the first wearable device 301, the second wearable device 302) over time, while the wearable device is charged. A horizontal axis of the graph 602 may represent time. A unit of the horizontal axis of the graph 602 may be minutes. A vertical axis of the graph 602 may represent current. A unit of the vertical axis of the graph 602 may be milliamperes (mA).

According to an embodiment, a line 605 may indicate a current obtained by the wearable device. For example, the line 605 may be referenced as a current provided to the wearable device by the charging device 201 via an interface (e.g., the first interface 251, the second interface 252).

According to an embodiment, at a time interval 610, the line 603 may indicate about 4.8 V. The line 604 may indicate that the battery voltage increases from less than about 3 V to about 3.2 V. The line 605 may indicate about 8 mA.

According to an embodiment, at a time interval 620, the line 603 may indicate about 4.2 V. The line 604 may indicate that the battery voltage increases from about 3.2 V to about 4.12 V. The line 605 may indicate about 104 mA.

According to an embodiment, at a time interval 630, the line 603 may indicate about 4.4 V. The line 604 may indicate that the battery voltage decreases from about 4.12 V to about 4.05 V. The line 605 may indicate a decrease from about 104 mA to about 35 mA.

According to an embodiment, at a time interval 640, the line 603 may indicate about 4.6 V. The line 604 may indicate that the battery voltage increases from about 4.05 V to about 4.35 V. The line 605 may indicate about 35 mA.

According to an embodiment, at a time interval 650, the line 603 may indicate about 4.8 V. The line 604 may indicate that the battery voltage is greater than or equal to about 4.35 V. The wearable device may be in a fully charged state. The line 605 may indicate a decrease from about 35 mA to about 10 mA.

According to an embodiment, at a time interval 660, the line 603 may indicate about 4.8 V. The line 604 may indicate that the battery voltage is greater than or equal to about 4.35 V. The wearable device may be in a fully charged state. The line 605 may indicate a decrease from about 10 mA to about 5 mA.

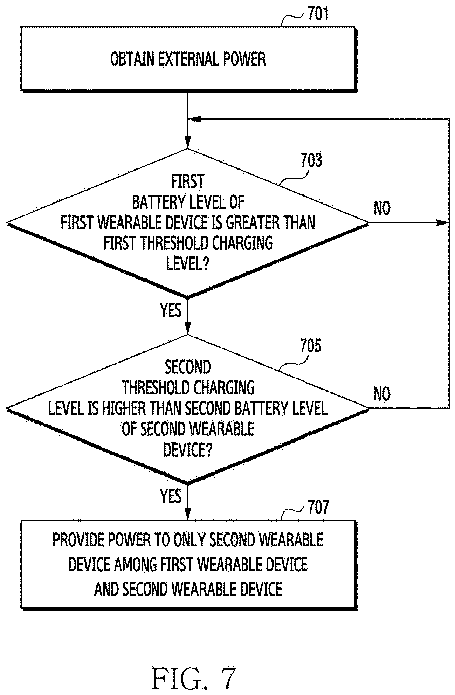

FIG. 7 illustrates an example of operations of a charging device (e.g., the charging device 201) that charges wearable devices (e.g., the first wearable device 301, the second wearable device 302) while obtaining external power. In the present disclosure, for convenience of explanation, the first wearable device 301 may be determined to be the secondary device, and the second wearable device 302 may be determined to be the primary device. A frequency of use of the second wearable device 302 determined to be the primary device is determined to be higher than a frequency of use of the first wearable device 301 determined to be the secondary device.

Referring to FIG. 7, in operation 701, the charging device 201 (e.g., the at least one processor 200) may obtain external power via power input circuitry (e.g., the power input circuitry 220). The charging device 201 may charge the first wearable device 301 and the second wearable device 302 using the obtained external power. The charging device 201 may provide power to the first wearable device 301 via a first interface 251 and to the second wearable device 302 via a second interface 252, by using the obtained external power. For example, the amount of power provided to the first wearable device 301 and the amount of power provided to the second wearable device 302 may be the same or corresponding.

In operation 703, the charging device 201 (e.g., the at least one processor 200) may identify whether a first battery level of the first wearable device 301 is greater than a first threshold charging level. The first battery level may indicate a charge amount of a battery (e.g., the battery 332) of the first wearable device 301. The first threshold charging level may be described as a charge amount of a battery targeted by the charging device 201 by charging the battery 332 of the first wearable device 301. The descriptions of the first threshold charging level in FIGS. 3, 4, 5A, and/or 5B may be referenced for the first threshold charging level. The charging device 201 may execute operation 705, in accordance with a determination that the first battery level of the first wearable device is greater than the first threshold charging level (or is not less than the first threshold charging level, or is not lower than the first threshold charging level). The charging device 201 may execute operation 703 again, in accordance with a determination that the first battery level of the first wearable device is not greater than the first threshold charging level (or is less than the first threshold charging level, or is lower than the first threshold charging level). According to an embodiment, the charging device 201 may charge the first wearable device 301 and the second wearable device 302 using external power obtained via the power input circuitry 220, in accordance with a determination that the first battery level of the first wearable device is not greater than the first threshold charging level (or is less than the first threshold charging level, or is lower than the first threshold charging level). The charging device 201 may provide power to the first wearable device 301 via the first interface 251 and to the second wearable device 302 via the second interface 252, by using the obtained external power. For example, the amount of power provided to the first wearable device 301 and the amount of power provided to the second wearable device 302 may be the same or corresponding.

FIG. 7 illustrates that the charging device 201 executes operation 705 in accordance with a determination that the first battery level of the first wearable device is greater than the first threshold charging level (or is not less than the first threshold charging level, or is not lower than the first threshold charging level), but this is merely exemplary and embodiments of the present disclosure are not limited thereto. As a non-limiting example, the charging device 201 may execute operation 705, in response to executing operation 701.

In operation 705, the charging device 201 (e.g., the at least one processor 200) may identify whether a second threshold charging level is higher than a second battery level of the second wearable device 302. The second battery level may indicate a charge amount of a battery (e.g., the battery 342) of the second wearable device 302. The second threshold charging level may be described as a charge amount of the battery targeted by the charging device 201 by charging the battery 342 of the second wearable device 302. The descriptions of the second threshold charging level in FIGS. 3, 4, 5A and/or 5B may be referenced for the second threshold charging level. The charging device 201 may execute operation 707, in accordance with a determination that the second threshold charging level is higher than the second battery level of the second wearable device 302 (or is not less than the second battery level, or is not lower than the second battery level). The charging device 201 may execute operation 703 again, in accordance with a determination that the second threshold charging level is not greater than the second battery level of the second wearable device 302 (or is less than the second battery level, or is lower than the second battery level). According to an embodiment, the charging device 201 may charge the first wearable device 301 and the second wearable device 302 using external power obtained via the power input circuitry 220, in accordance with a determination that the second threshold charging level is not greater than or equal to the second battery level of the second wearable device 302 (or is less than the second battery level, or is lower than the second battery level). The charging device 201 may provide power to the first wearable device 301 via the first interface 251 and to the second wearable device 302 via the second interface 252, by using the obtained external power. For example, the amount of power provided to the first wearable device 301 and the amount of power provided to the second wearable device 302 may be the same or corresponding.

In operation 707, the charging device 201 (e.g., the at least one processor 200) may provide power to only the second wearable device 302 among the first wearable device 301 and the second wearable device 302 via the second interface 252. For example, the charging device 201 may charge only the second wearable device 302. For example, the charging device 201 may connect only the second wearable device 302 among the first wearable device 301 and the second wearable device 302 to the power input circuitry 220. For example, the charging device 201 may connect the second wearable device 302 and the power input circuitry 220, instead of connecting the first wearable device 301 and the power input circuitry 220. For example, the charging device 201 may disconnect the first wearable device 301 and the power input circuitry 220, and connect the second wearable device 302 and the power input circuitry 220 via the second interface 252. For example, the charging device 201 may establish a charging connection between the second wearable device 302 and the power input circuitry 220 without a charging connection between the first wearable device 301 and the power input circuitry 220. For example, the charging device 201 may refrain from or block providing power to the first wearable device 301, and provide power to the second wearable device 302 via the second interface 252. The charging device 201 may increase the amount of power provided to the second wearable device 302 by refraining from or blocking providing power to the first wearable device 301. For example, the amount of power provided to the second wearable device 302 by refraining from or blocking providing power to the first wearable device 301 may be greater than the amount (or magnitude) of power provided to the second wearable device 202 before refraining from or blocking providing power to the first wearable device 301. For example, when refraining from or blocking providing power to the first wearable device 301, a charging speed of the second wearable device 202 may be faster than a charging speed of the second wearable device 302 before refraining from or blocking providing power to the first wearable device 301. Operation 707 may correspond to operation 409 of FIG. 4.

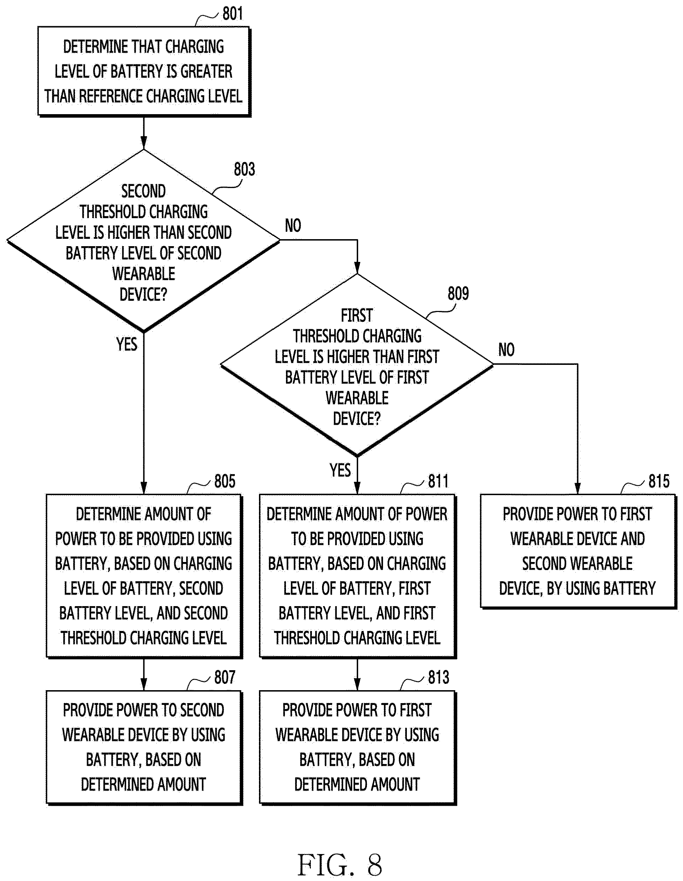

FIG. 8 illustrates an example of operations of a charging device (e.g., the charging device 201) that charges wearable devices (e.g., the first wearable device 301 and the second wearable device 302) while not obtaining external power.

Referring to FIG. 8, in operation 801, the charging device 201 (e.g., the at least one processor 200) may determine that a charging level of a battery (e.g., the battery 230) is greater than a reference charging level. The charging level of the battery 230 may be described as a charge amount (or electric capacity) of the battery 230 used to charge wearable devices (e.g., the first wearable device 301 and the second wearable device 302). For example, the reference charging level may be described as a reference level for the charging device 201 to provide power to the wearable devices by using the charging level (or charge amount) of the battery 230. For example, when the charging level of the battery 230 is higher than or equal to the reference charging level, the wearable devices (e.g., the first wearable device 301 and the second wearable device 302) may obtain power from the battery 230. For example, a reference state of charge (SOC) of the battery 230 indicated by the reference charging level may include 'about 0 %'.

According to an embodiment, the charging device 201 may execute operation 801 while not obtaining external power via power input circuitry (e.g., the power input circuitry 220).

In operation 803, the charging device 201 (e.g., the at least one processor 200) may determine whether a second threshold charging level is higher than the second battery level of the second wearable device 302. The charging device 201 can execute operation 805, in accordance with a determination that the second threshold charging level is higher than the second battery level of the second wearable device 302 (or is not less than the second battery level, or is not lower than the second battery level). The charging device 201 may execute operation 809, in accordance with a determination that the second threshold charging level is not higher than the second battery level of the second wearable device 302 (or is less than the second battery level, or is lower than the second battery level).

In operation 805, the charging device 201 (e.g., the at least one processor 200) may determine the amount of power (or voltage) to be provided to the second wearable device 302 using the battery 230, based on the charging level of the battery 230, the second battery level, and the second threshold charging level.

According to an embodiment, the following equation may be referred to as a method for determining the amount of power (or voltage) to be provided to a wearable device 301, 302 using the battery 230 by the charging device 201.

[Equation 5]

$$Cap_e = \begin{cases} CHG\_th_e - Batt_e, & (\text{if } Batt_C \geq CHG\_th_e - Batt_e) \\ Batt_C, & (\text{otherwise}) \end{cases}$$

In Equation 5, $Cap_e$ may indicate an electric capacity corresponding to the amount of power to be provided to a wearable device (e.g., the first wearable device 301, the second wearable device 302). $CHG\_th_e$ may indicate an electric capacity corresponding to a threshold charging level (e.g., the first threshold charging level, the second threshold charging level). $Batt_e$ may indicate an electric capacity corresponding to a battery level of a wearable device (e.g., the first wearable device 301, the second wearable device 302). $Batt_C$ may indicate an electric capacity corresponding to a charging level (or SOC) of the battery 230 of the charging device 201.

According to an embodiment, the charging device 201 may determine the amount of power (or voltage) to be provided to the second wearable device 302 using the battery 230 according to [Equation 5]. For example, the charging device 201 may determine the amount of power (or voltage) to be provided to the second wearable device 302, based on a smaller one of an electric capacity corresponding to a difference between the second threshold charging level and the second battery level and an electric capacity corresponding to the charging level of the battery 230.

In operation 807, the charging device 201 (e.g., the at least one processor 200) may provide power to the second wearable device 302 via the second interface 252, by using the battery 230, based on the amount of power determined in operation 805. For example, the charging device 201 may connect the second wearable device 302 and the battery 230. The charging device 201 may provide, to the second wearable device 302, power corresponding to the determined amount using the battery 230. The charging device 201 may charge the second wearable device 302, by providing power corresponding to the determined amount using the battery 230.

According to an embodiment, the charging device 201 may connect the first wearable device 301 and the battery 230 via the first interface 251, after the second wearable device 302 and the battery 230 are connected. For example, the charging device 201 may provide remaining power of the battery 230 to the second wearable device 302. The charging device 201 may charge the first wearable device 301 by using the remaining power of the battery 230.

In operation 809, the charging device 201 (e.g., the at least one processor 200) may identify whether the first threshold charging level is higher than the first battery level of the first wearable device 301. The charging device 201 may execute operation 811, in accordance with a determination that the first threshold charging level is higher than the first battery level of the first wearable device 301 (or is not less than the first battery level, or is not lower than the first battery level). The charging device 201 may execute operation 815, in accordance with a determination that the first threshold charging level is not higher than the first battery level of the first wearable device 301 (or is less than the first battery level, or is lower than the first battery level).

In operation 811, the charging device 201 (e.g., the at least one processor 200) may determine the amount of power (or voltage) to be provided to the first wearable device 301, by using the battery 230, based on the charging level of the battery 230, the first battery level, and the first threshold charging level. For example, the charging device 201 may determine the amount of power (or voltage) to be provided to the first wearable device 301 using the battery 230, in accordance with [Equation 5]. For example, the charging device 201 may determine the amount of power (or voltage) to be provided to the first wearable device 301, based on a smaller one of an electric capacity corresponding to a difference between the first threshold charging level and the first battery level and an electric capacity corresponding to the charging level of the battery 230.

In operation 813, the charging device 201 (e.g., the at least one processor 200) may provide power to the first wearable device 301 via the first interface 251 using the battery 230, based on the amount of power determined in operation 811. For example, the charging device 201 may connect the first wearable device 301 and the battery 230. The charging device 201 may provide, to the first wearable device 301, power corresponding to the determined amount using the battery 230. The charging device 201 may charge the first wearable device 301 based on providing power corresponding to the determined amount using the battery 230.

In operation 815, the charging device 201 (e.g., the at least one processor 200) may provide power to the first wearable device 301 via the first interface 251 and to the second wearable device 302 via the second interface 252, by using the battery 230. For example, the charging device 201 may connect the first wearable device 301 and the battery 230 via the first interface 251 and connect the second wearable device 302 and the battery 230 via the second interface 252. For example, the charging device 201 may provide power to the first wearable device 301 via the first interface 251 and to the second wearable device 302 via the second interface 252, by using the battery 230. For example, the charging device 201 may charge the first wearable device 301 and the second wearable device 302, by using the battery 230.

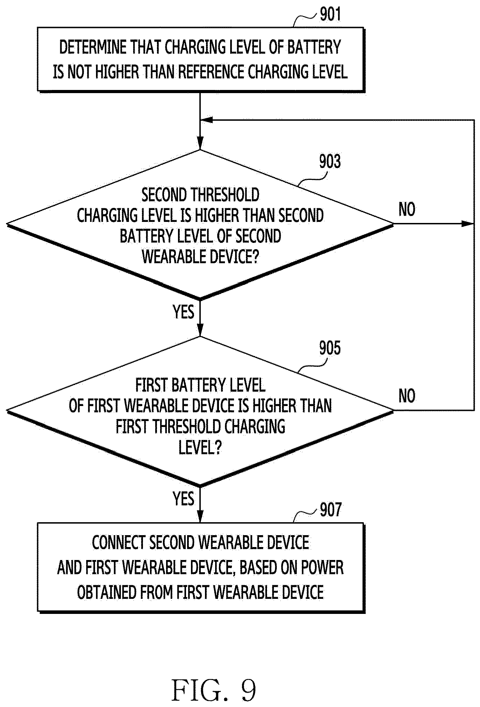

FIG. 9 illustrates an example of other operations of a charging device (e.g., the charging device 201) that charges wearable devices (e.g., the first wearable device 301 and the second wearable device 302) while not obtaining external power.

Referring to FIG. 9, in operation 901, the charging device 201 (e.g., the at least one processor 200) may determine that a charging level of a battery (e.g., the battery 230) is not higher than a reference charging level. The charging level of the battery 230 may be described as a charge amount (or electric capacity) of the battery 230 used to charge wearable devices (e.g., the first wearable device 301 and the second wearable device 302). For example, the reference charging level may be described as a reference level for the charging device 201 to provide power to the wearable devices by using a charging level (or charge amount) of the battery 230. For example, when the charging level of the battery 230 is higher than or equal to the reference charging level, wearable devices (e.g., the first wearable device 301 and the second wearable device 302) may obtain power from the battery 230. For example, a reference state of charge (SOC) of the battery 230 indicated by the reference charging level may include 'about 0 %'.

According to an embodiment, the charging device 201 may execute operation 901 while not obtaining external power via power input circuitry (e.g., the power input circuitry 220).

In operation 903, the charging device 201 (e.g., the at least one processor 200) may determine whether the second threshold charging level is higher than the second battery level of the second wearable device 302. The charging device 201 may execute operation 905, in accordance with a determination that the second threshold charging level is higher than the second battery level of the second wearable device 302 (or is not less than the second battery level, or is not lower than the second battery level). The charging device 201 may execute operation 903 again, in accordance with a determination that the second threshold charging level is not higher than the second battery level of the second wearable device 302 (or is less than the second battery level, or is lower than the second battery level).

FIG. 9 illustrates that the charging device 201 executes operation 905 in accordance with a determination that the second threshold charging level is higher than the second battery level of the second wearable device 302 (or is not less than the second battery level, or is not lower than the second battery level), but this is merely exemplary and embodiments of the present disclosure are not limited thereto. As a non-limiting example, the charging device 201 may execute operation 907, in accordance with a determination that the second threshold charging level is higher than the second battery level of the second wearable device 302 (or is not less than the second battery level, or is not lower than the second battery level).

In operation 905, the charging device 201 (e.g., the at least one processor 200) may identify whether the first battery level of the first wearable device 301 is higher than the first threshold charging level. The charging device 201 may execute operation 907, in accordance with a determination that the first battery level of the first wearable device is higher than the first threshold charging level (or is not less than the first threshold charging level, or is not lower than the first threshold charging level). The charging device 201 may execute operation 903 again, in accordance with a determination that the first battery level of the first wearable device is not higher than the first threshold charging level (or is less than the first threshold charging level, or is lower than the first threshold charging level).

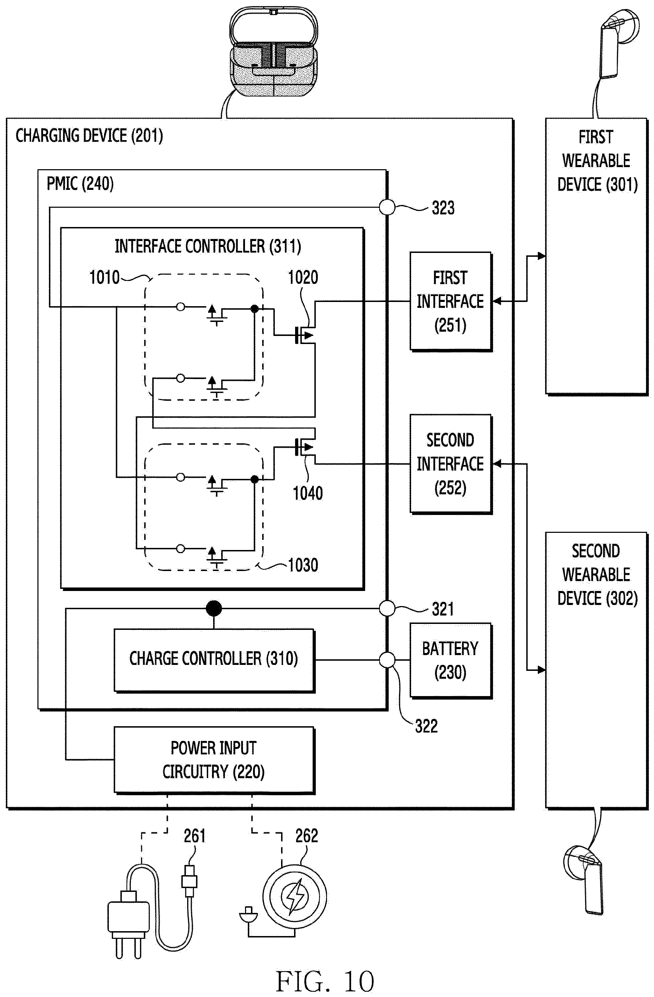

In operation 907, the charging device 201 (e.g., the at least one processor 200) may connect the second wearable device 302 and the first wearable device 301, based on the power obtained from the first wearable device 301. The charging device 201 may be connected to the first wearable device 301 via the first interface 251. The charging device 201 may be connected to the second wearable device 302 via the second interface 252. The charging device 201 may obtain power from the first wearable device 301. A method for the charging device 201 to obtain power from the first wearable device 301 will be described and exemplified with reference to FIG. 10.

According to an embodiment, the charging device 201 may provide power obtained from the first wearable device 301 to the second wearable device 302. The charging device 201 may charge the second wearable device 302 using the power obtained from the first wearable device 301.

According to an embodiment, the charging device 201 may obtain battery information (e.g., the battery information 500) from the first wearable device 301 via the first interface 251, after the second wearable device 302 and the first wearable device 301 are connected. The charging device 201 may identify a battery level of the first wearable device 301 from the battery information. The charging device 201 may disconnect a connection between the second wearable device 302 and the first wearable device 301, in accordance with a determination that the identified battery level is less than the first threshold charging level. For example, the charging device 201 may refrain from, stop, or block providing power obtained from the first wearable device 301 to the second wearable device 302, in accordance with a determination that the identified battery level is less than the first threshold charging level. In this way, the charging device 201 may ensure usability of the first wearable device 301 by refraining from, stopping, or blocking providing power obtained from the first wearable device 301 to the second wearable device 302. For example, the charging device 201 may refrain from, stop, or block charging the second wearable device 302 using power obtained from the first wearable device 301, in accordance with a determination that the identified battery level is less than the first threshold charging level.

According to an embodiment, the charging device 201 may obtain battery information (e.g., the battery information 500) from the second wearable device 302 via the second interface 252, after the second wearable device 302 and the first wearable device 301 are connected. The charging device 201 may identify a battery level of the second wearable device 302 from the battery information. The charging device 201 may disconnect a connection between the second wearable device 302 and the first wearable device 301, in accordance with a determination that the identified battery level is higher than the second threshold charging level. For example, the charging device 201 may refrain from, stop, or block providing power obtained from the first wearable device 301 to the second wearable device 302, in accordance with a determination that the identified battery level is higher than the second threshold charging level. The charging device 201 may ensure usability of the first wearable device 301 and ensure usability of the second wearable device 301, by refraining from, stopping, or blocking providing power obtained from the first wearable device 301 to the second wearable device 302, in accordance with a determination that the identified battery level is higher than the second threshold charging level.

FIG. 10 illustrates an example of a charging device (e.g., the charging device 201) that provides power obtained from a first wearable device (e.g., the first wearable device 301) to a second wearable device (e.g., the second wearable device 302). In embodiments according to the present disclosure, providing power may include supplying power, transmitting power, and/or applying power. In addition, in the present disclosure, the battery level may be referred to as a charge amount of battery, a state of charge (SOC) of battery, and/or other terms with an equivalent technical meaning. In the following examples, for convenience of explanation, the first wearable device 301 may be determined as a secondary device, and the second wearable device 302 may be determined as a primary device. A frequency of use of the second wearable device 302 determined as the primary device may be determined to be higher than a frequency of use of the first wearable device 301 determined as the secondary device. FIG. 10 may be related to operation 907 of FIG. 9. At least a portion of components of the charging device 201 illustrated in FIG. 10 may be substantially the same as at least a portion of the components of the charging device 201 illustrated in FIG. 3, and therefore, any redundant descriptions will be omitted.

Referring to FIG. 10, the PMIC 240 may include switch circuitry 1010, a switch 1020, switch circuitry 1030, and/or a switch 1040. The switch circuitry 1010 may be configured to optionally connect the switch 1020 and an input terminal 323, or to connect the switch 1020 and the switch 1040. The switch 1020 may be configured to optionally connect the first interface 251 and the switch circuitry 1030, or to connect the first interface 251 and the switch circuitry 1010. The switch circuitry 1030 may be configured to optionally connect the switch 1040 and the input terminal 323, or to connect the switch 1040 and the switch 1020. The switch 1040 may be configured to optionally connect a second interface 252 and the switch circuitry 1010 or to connect the second interface 252 and the switch circuitry 1030.

According to an embodiment, the charging device 201 may be configured to obtain power from the first wearable device 301. The charging device 201 may be configured to provide the power obtained from the first wearable device 301 to the second wearable device 302. The charging device 201 may be connected to the first wearable device 301 via the first interface 251.

According to an embodiment, the charging device 201 may obtain power from the first wearable device 301 via the first interface 251, in accordance with a determination that a charging level of the battery 230 is not higher than a reference charging level, while not obtaining external power via the power input circuitry 220. The charging device 201 may control the switch 1020 to connect the first interface 251 and the switch circuitry 1030. For example, the charging device 201 may provide power obtained from the first wearable device 301 to the switch circuitry 1030 by using the switch 1020.

The charging device 201 may control the switch circuitry 1030 so that the switch 1020 and the switch 1040 are connected. For example, the charging device 201 may provide power obtained from the first wearable device 301 to the switch 1040, by using the switch circuitry 1030. The charging device 201 may control the switch 1040 so that the switch circuitry 1030 and the second interface 252 are connected. For example, the charging device 201 may provide power obtained from the first wearable device 301 to the second interface 252, by using the switch 1040. The charging device 201 may be connected to the second wearable device 302 via the second interface 252. For example, the charging device 201 may provide power obtained from the first wearable device 301 to the second wearable device 202 via the second interface 252.

As a non-limiting example, the charging device 201 may be configured to provide power obtained from the second wearable device 302 to the first wearable device 301. The charging device 201 may be connected to the second wearable device 302 via the second interface 252.

According to an embodiment, the charging device 201 may obtain power from the second wearable device 302 via the second interface 252, in accordance with a determination that the charging level of the battery 230 is not higher than the reference charging level, while not obtaining external power via the power input circuitry 220. The charging device 201 may control the switch 1040 so that the second interface 252 and the switch circuitry 1010 are connected. For example, the charging device 201 may provide power obtained from the second wearable device 302 to the switch circuitry 1010 by using the switch 1040.

The charging device 201 may control the switch circuitry 1010 so that the switch 1040 and the switch 1010 are connected. For example, the charging device 201 may provide power obtained from the second wearable device 302 to the switch 1020, by using the switch circuitry 1010. The charging device 201 may control the switch 1020 so that the switch circuitry 1010 and the first interface 251 are connected. For example, the charging device 201 may provide power obtained from the second wearable device 302 to the first interface 251 by using the switch 1020. The charging device 201 may be connected to the first wearable device 301 via the first interface 251. For example, the charging device 201 may provide power obtained from the second wearable device 302 to the first wearable device 201 via the first interface 251.

FIG. 11 illustrates an example of a first wearable device (e.g., the first wearable device 301) for charging wearable devices (e.g., the first wearable device 301, the second wearable device 302) using a charging device 201.

In embodiments according to the present disclosure, providing power may include supplying power, transmitting power, and/or applying power. In addition, in the present disclosure, the battery level may be referred to as a charge amount of battery, a state of charge (SOC) of battery, and/or other terms with an equivalent technical meaning. In the following examples, for convenience of explanation, the first wearable device 301 may be determined as a secondary device, and the second wearable device 302 may be determined as a primary device. A frequency of use of the second wearable device 302 determined as the primary device may be determined to be higher than a frequency of use of the first wearable device 301 determined as the secondary device.

The first wearable device 301 may include at least one processor 1100, memory 1110, a battery 332, and/or a PMIC 330. The descriptions for the battery 332 of FIG. 3 may be referenced for the battery 332. The descriptions for the PMIC 330 of FIG. 3 may be referenced for the PMIC 330.

The at least one processor 1100 may include a hardware component for processing data based on executing instructions. The at least one processor 1100 may be configured to individually or collectively execute instructions stored in the memory 1110. The at least one processor 1100 may include processing circuitry. For example, the hardware component for processing data may include an arithmetic and logic unit (ALU), a floating point unit (FPU), a field programmable gate array (FPGA). For example, the hardware component for processing data may include a central processing unit (CPU), a graphic processing unit (GPU), a display processing unit (DPU), a neural processing unit (NPU), a digital signal processor (DSP), an application processor (AP), and/or a microcontroller (MCU). The at least one processor 1100 may include one or more cores. For example, the at least one processor 1100 may have a multi-core processor structure such as a dual core, a quad core, or a hexa core. The description of the processor 120 of FIG. 1 may be applied to the at least one processor 1100 of FIG. 11.

The memory 1110 may include a hardware component for storing data and/or instructions input to and/or output from the at least one processor 1100. The memory 1110 may include one or more storage media. For example, the memory 1110 may include a volatile memory such as random-access memory (RAM) and/or a non-volatile memory such as read-only memory (ROM). For example, the volatile memory may include at least one of dynamic RAM (DRAM), static RAM (SRAM), cache RAM, or pseudo SRAM (PSRAM). For example, the nonvolatile memory may include at least one of programmable ROM (PROM), erasable PROM (EPROM), electrically erasable PROM (EEPROM), flash memory, hard disk, compact disk, or embedded multimedia card (EMMC). The description of the memory 130 of FIG. 1 may be applied to the memory 1110 of FIG. 11.

In an embodiment, in the memory 1110 of the first wearable device 301, one or more instructions (or commands) indicating calculation and/or operation to be performed by the at least one processor 1000 of the charging device 301 on data may be stored. A set of one or more instructions may be referred to as program, firmware, operating system, process, routine, subroutine and/or application.

According to an embodiment, the first wearable device 301 (e.g., the at least one processor 1100) may transmit a control signal to the charging device 201 via a first interface (e.g., the first interface 251). The charging device 201 (e.g., the at least one processor 200) may, in response to the control signal, execute at least a portion of the operations of the charging device 201 illustrated in FIGS. 3, 4, 5A, 5B, 6, 7, 8, 9, and/or 10.

As a non-limiting example, the first wearable device 301 and the second wearable device 302 may be substantially identical. The second wearable device 302 may transmit a control signal to the charging device 201 via a second interface (e.g., the second interface 252). The charging device 201 (e.g., the at least one processor 200) may, in response to the control signal, execute at least a portion of the operations of the charging device 201 exemplified in FIGS. 3, 4, 5A, 5B, 6, 7, 8, 9, and/or 10.

In an embodiment according to the present disclosure, a charging device (e.g., the charging device 201) may charge a wearable device (e.g., the second wearable device 302) determined as a primary device prior to a wearable device (e.g., the first wearable device 301) determined as a secondary device, by executing the operations of FIGS. 4, 5A, 5B, 6, 7, 8, 9, and/or 10. A frequency of use of the primary device may be greater than a frequency of use of the secondary device. By charging the second wearable device 302 determined as the primary device prior to the first wearable device 301 determined as the secondary device, available time of the wearable device 301 perceived by the user may increase. The charging device 201 may provide an enhanced user experience.

The effects that can be obtained from the present disclosure are not limited to those described above, and any other effects not mentioned herein will be clearly understood by those having ordinary knowledge in the art to which the present disclosure belongs, from the following description.

The technical problems to be achieved in this document are not limited to those described above, and other technical problems not mentioned herein will be clearly understood by those having ordinary knowledge in the art to which the present disclosure belongs, from the following description.

As described above, a charging device may comprise a first interface for connecting with a first wearable device. The charging device may comprise a second interface for connecting with a second wearable device. The charging device may comprise memory comprising one or more storage media storing instructions. The charging device may comprise at least one processor comprising processing circuitry. The instructions, when executed by the at least one processor individually or collectively, may cause the charging device to obtain a first threshold charging level corresponding to the first wearable device using the first interface. The instructions, when executed by the at least one processor individually or collectively, may cause the charging device to obtain a second threshold charging level corresponding to the second wearable device using the second interface. The instructions, when executed by the at least one processor individually or collectively, may cause the charging device to, based on identifying the second threshold charging level greater than the first threshold charging level, The instructions, when executed by the at least one processor individually or collectively, may cause the charging device to, based on identifying the second threshold charging level greater than the first threshold charging level, in accordance with a determination that a battery level of the first wearable device identified using the first interface is less than the first threshold charging level, provide power to the first wearable device via the first interface and provide power to the second wearable device via the second interface. The instructions, when executed by the at least one processor individually or collectively, may cause the charging device to, based on identifying the second threshold charging level greater than the first threshold charging level, in accordance with a determination that the battery level is not less than the first threshold charging level, provide power only to the second wearable device among the first wearable device and the second wearable device via the second interface.

According to an embodiment, the first threshold charging level may be obtained based on first battery information obtained from the first wearable device while the first wearable device is connected to the charging device via the first interface. The second threshold charging level may be obtained based on second battery information obtained from the second wearable device while the second wearable device is connected to the charging device via the second interface.

According to an embodiment, each of the first threshold charging level and the second threshold charging level may be determined based on a usage proportion of second cumulative charging time of the second wearable device obtained in accordance with the second battery information to first cumulative charging time of the first wearable device obtained in accordance with the first battery information.

According to an embodiment, an amount of power provided to the second wearable device in accordance with a determination that the battery level is less than the first threshold charging level may be less than an amount of power provided to the second wearable device in accordance with a determination that the battery level is not less than the first threshold charging level.

According to an embodiment, the instructions, when executed by the at least one processor individually or collectively, may cause the charging device to, based on identifying the second threshold charging level greater than the first threshold charging level, in accordance with a determination that the battery level is not less than the first threshold charging level, refrain from providing power to the first wearable device, and provide power to the second wearable device via the second interface.

According to an embodiment, the charging device may comprise power input circuitry for obtaining external power. The instructions, when executed by the at least one processor individually or collectively, may cause the charging device to, based on identifying the second threshold charging level greater than the first threshold charging level, in accordance with a determination that the battery level is less than the first threshold charging level, connect the first wearable device and the power input circuitry via the first interface, and connect the second wearable device and the power input circuitry via the second interface. The instructions, when executed by the at least one processor individually or collectively, may cause the charging device to, based on identifying the second threshold charging level greater than the first threshold charging level, in accordance with a determination that the battery level is not less than the first threshold charging level, connect only the second wearable device among the first wearable device and the second wearable device to the power input circuitry via the second interface.

According to an embodiment, the charging device may comprise a battery. The instructions, when executed by the at least one processor individually or collectively, may cause the charging device to, in accordance with a determination that the first threshold charging level is less than the second threshold charging level and a charging level of the battery is greater than a reference charging level, based on the charging level of the battery, a second battery level of the second wearable device identified using the second interface, and the second threshold charging level, determine an amount of power to be provided to the second wearable device using the battery. The instructions, when executed by the at least one processor individually or collectively, may cause the charging device to, in accordance with a determination that the first threshold charging level is less than the second threshold charging level and a charging level of the battery is greater than a reference charging level, based on the determined amount, using the battery, provide power to the second wearable device via the second interface. The instructions, when executed by the at least one processor individually or collectively, may cause the charging device to, in accordance with a determination that the first threshold charging level is less than the second threshold charging level and a charging level of the battery is greater than a reference charging level, after providing the power to the second wearable device using the battery, provide power to the first wearable device via the first interface.

According to an embodiment, the instructions, when executed by the at least one processor individually or collectively, may cause the charging device to, in accordance with a determination that the first threshold charging level is less than the second threshold charging level and the charging level of the battery is not greater than the reference charging level, obtain power from the first wearable device via the first interface. The instructions, when executed by the at least one processor individually or collectively, may cause the charging device to, in accordance with a determination that the first threshold charging level is less than the second threshold charging level and the charging level of the battery is not greater than the reference charging level, based on the obtained power, connect, via the second interface, the second wearable device and the first wearable device connected to the first interface.

According to an embodiment, the instructions, when executed by the at least one processor individually or collectively, may cause the charging device to, after the second wearable device and the first wearable device connected to the first interface are connected, obtain battery information from the first wearable device. The instructions, when executed by the at least one processor individually or collectively, may cause the charging device to, in accordance with a determination that a third battery level identified from the battery information is less than the first threshold charging level, disconnect a connection between the second wearable device and the first wearable device connected to the first interface.

According to an embodiment, the instructions, when executed by the at least one processor individually or collectively, may cause the charging device to, after the second wearable device and the first wearable device connected to the first interface are connected, obtain battery information from the second wearable device. The instructions, when executed by the at least one processor individually or collectively, may cause the charging device to, in accordance with a determination that a third battery level identified from the battery information is greater than the second threshold charging level, disconnect a connection between the second wearable device and the first wearable device connected to the first interface.

As described above, a method performed by a charging device with a first interface for connecting with a first wearable device and a second interface for connecting with a second wearable device may comprise obtaining a first threshold charging level corresponding to the first wearable device using the first interface. The method may comprise obtaining a second threshold charging level corresponding to the second wearable device using the second interface. The method may comprise, based on identifying the second threshold charging level greater than the first threshold charging level, in accordance with a determination that a battery level of the first wearable device identified using the first interface is less than the first threshold charging level, providing power to the first wearable device via the first interface and providing power to the second wearable device via the second interface. The method may comprise, based on identifying the second threshold charging level greater than the first threshold charging level, in accordance with a determination that the battery level is not less than the first threshold charging level, providing power only to the second wearable device among the first wearable device and the second wearable device via the second interface.

According to an embodiment, the first threshold charging level may be obtained based on first battery information obtained from the first wearable device while the first wearable device is connected to the charging device via the first interface. The second threshold charging level may be obtained based on second battery information obtained from the second wearable device while the second wearable device is connected to the charging device via the second interface.

According to an embodiment, each of the first threshold charging level and the second threshold charging level may be determined based on a usage proportion of second cumulative charging time of the second wearable device obtained in accordance with the second battery information to first cumulative charging time of the first wearable device obtained in accordance with the first battery information.

According to an embodiment, an amount of power provided to the second wearable device in accordance with a determination that the battery level is less than the first threshold charging level may be less than an amount of power provided to the second wearable device in accordance with a determination that the battery level is not less than the first threshold charging level.

According to an embodiment, the method may comprise, based on identifying the second threshold charging level greater than the first threshold charging level, in accordance with a determination that the battery level is not less than the first threshold charging level, refraining from providing power to the first wearable device, and providing power to the second wearable device via the second interface.

According to an embodiment, the charging device may comprises power input circuitry for obtaining external power. The method may comprise, based on identifying the second threshold charging level greater than the first threshold charging level, in accordance with a determination that the battery level is less than the first threshold charging level, connecting the first wearable device and the power input circuitry via the first interface, and connecting the second wearable device and the power input circuitry via the second interface. The method may comprise, based on identifying the second threshold charging level greater than the first threshold charging level, in accordance with a determination that the battery level is not less than the first threshold charging level, connecting only the second wearable device among the first wearable device and the second wearable device to the power input circuitry input circuitry via the second interface.

According to an embodiment, the charging device may comprise a battery. The method may comprise, in accordance with a determination that the first threshold charging level is less than the second threshold charging level and a charging level of the battery is greater than a reference charging level, based on the charging level of the battery, a second battery level of the second wearable device identified using the second interface, and the second threshold charging level, determining an amount of power to be provided to the second wearable device using the battery. The method may comprise, in accordance with a determination that the first threshold charging level is less than the second threshold charging level and a charging level of the battery is greater than a reference charging level, based on the determined amount, using the battery, providing power to the second wearable device via the second interface. The method may comprise, in accordance with a determination that the first threshold charging level is less than the second threshold charging level and a charging level of the battery is greater than a reference charging level, after providing the power to the second wearable device using the battery, providing power to the first wearable device via the first interface.

According to an embodiment, the method may comprise, in accordance with a determination that the first threshold charging level is less than the second threshold charging level and the charging level of the battery is not greater than the reference charging level, obtaining power from the first wearable device via the first interface. The method may comprise, in accordance with a determination that the first threshold charging level is less than the second threshold charging level and the charging level of the battery is not greater than the reference charging level, based on the obtained power, connecting, via the second interface, the second wearable device and the first wearable device connected to the first interface.

According to an embodiment, the method may comprise after the second wearable device and the first wearable device connected to the first interface are connected, obtaining battery information from the first wearable device. The method may comprise, in accordance with a determination that a third battery level identified from the battery information is less than the first threshold charging level, disconnecting a connection between the second wearable device and the first wearable device connected to the first interface.

According to an embodiment, the method may comprise, after the second wearable device and the first wearable device connected to the first interface are connected, obtaining battery information from the second wearable device. The method may comprise, in accordance with a determination that a third battery level identified from the battery information is greater than the second threshold charging level, disconnecting a connection between the second wearable device and the first wearable device connected to the first interface.

As described above, a non-transitory computer readable storage medium storing one or more programs, the one or more programs may comprise instructions to, when executed by a charging device with a first interface for connecting with a first wearable device and a second interface for connecting with a second wearable device, cause the charging device to obtain a first threshold charging level corresponding to the first wearable device using the first interface. The one or more programs may comprise instructions to, when executed by the charging device, cause the charging device to obtain a second threshold charging level corresponding to the second wearable device using the second interface. The one or more programs may comprise instructions to, when executed by the charging device, cause the charging device to, based on identifying the second threshold charging level greater than the first threshold charging level, in accordance with a determination that a battery level of the first wearable device identified using the first interface is less than the first threshold charging level, provide power to the first wearable device via the first interface and provide power to the second wearable device via the second interface. The one or more programs may comprise instructions to, when executed by the charging device, cause the charging device to, based on identifying the second threshold charging level greater than the first threshold charging level, in accordance with a determination that the battery level is not less than the first threshold charging level, provide power only to the second wearable device among the first wearable device and the second wearable device via the second interface.

According to an embodiment, the first threshold charging level may be obtained based on first battery information obtained from the first wearable device while the first wearable device is connected to the charging device via the first interface. The second threshold charging level may be obtained based on second battery information obtained from the second wearable device while the second wearable device is connected to the charging device via the second interface.

According to an embodiment, each of the first threshold charging level and the second threshold charging level may be determined based on a usage proportion of second cumulative charging time of the second wearable device obtained in accordance with the second battery information to first cumulative charging time of the first wearable device obtained in accordance with the first battery information.

According to an embodiment, an amount of power provided to the second wearable device in accordance with a determination that the battery level is less than the first threshold charging level may be less than an amount of power provided to the second wearable device in accordance with a determination that the battery level is not less than the first threshold charging level.

According to an embodiment, the one or more programs may comprise instructions to, when executed by the charging device, cause the charging device to, based on identifying the second threshold charging level greater than the first threshold charging level, in accordance with a determination that the battery level is not less than the first threshold charging level, refrain from providing power to the first wearable device, and provide power to the second wearable device via the second interface.

According to an embodiment, the charging device may comprise power input circuitry for obtaining external power. The one or more programs may comprise instructions to, when executed by the charging device, cause the charging device to, based on identifying the second threshold charging level greater than the first threshold charging level, in accordance with a determination that the battery level is less than the first threshold charging level, connect the first wearable device and the power input circuitry via the first interface, and connect the second wearable device and the power input circuitry via the second interface. The one or more programs may comprise instructions to, when executed by the charging device, cause the charging device to, based on identifying the second threshold charging level greater than the first threshold charging level, in accordance with a determination that the battery level is not less than the first threshold charging level, connect only the second wearable device among the first wearable device and the second wearable device to the power input circuitry via the second interface.

According to an embodiment, the charging device may comprise a battery. The one or more programs may comprise instructions to, when executed by the charging device, cause the charging device to, in accordance with a determination that the first threshold charging level is less than the second threshold charging level and a charging level of the battery is greater than a reference charging level, based on the charging level of the battery, a second battery level of the second wearable device identified using the second interface, and the second threshold charging level, determine an amount of power to be provided to the second wearable device using the battery. The one or more programs may comprise instructions to, when executed by the charging device, cause the charging device to, in accordance with a determination that the first threshold charging level is less than the second threshold charging level and a charging level of the battery is greater than a reference charging level, based on the determined amount, using the battery, provide power to the second wearable device via the second interface. The one or more programs may comprise instructions to, when executed by the charging device, cause the charging device to, in accordance with a determination that the first threshold charging level is less than the second threshold charging level and a charging level of the battery is greater than a reference charging level, after providing the power to the second wearable device using the battery, provide power to the first wearable device via the first interface.

According to an embodiment, the one or more programs may comprise instructions to, when executed by the charging device, cause the charging device to, in accordance with a determination that the first threshold charging level is less than the second threshold charging level and the charging level of the battery is not greater than the reference charging level, obtain power from the first wearable device via the first interface. The one or more programs may comprise instructions to, when executed by the charging device, cause the charging device to, in accordance with a determination that the first threshold charging level is less than the second threshold charging level and the charging level of the battery is not greater than the reference charging level, based on the obtained power, connect, via the second interface, the second wearable device and the first wearable device connected to the first interface.

According to an embodiment, the one or more programs may comprise instructions to, when executed by the charging device, cause the charging device to, after the second wearable device and the first wearable device connected to the first interface are connected, obtain battery information from the first wearable device. The one or more programs may comprise instructions to, when executed by the charging device, cause the charging device to, in accordance with a determination that a third battery level identified from the battery information is less than the first threshold charging level, disconnect a connection between the second wearable device and the first wearable device connected to the first interface.

According to an embodiment, the one or more programs may comprise instructions to, when executed by the charging device, cause the charging device to, after the second wearable device and the first wearable device connected to the first interface are connected, obtain battery information from the second wearable device. The one or more programs may comprise instructions to, when executed by the charging device, cause the charging device to, in accordance with a determination that a third battery level identified from the battery information is greater than the second threshold charging level, disconnect a connection between the second wearable device and the first wearable device connected to the first interface.

As described above, a charging device may comprise a first interface for connecting with a first wearable device. The charging device may comprise a second interface for connecting with a second wearable device. The charging device may comprise memory comprising one or more storage media storing instructions. The charging device may comprise at least one processor including processing circuitry. The instructions, when executed by the at least one processor individually or collectively, may cause the charging device to obtain a first threshold charging level, based on a time interval in which power is provided to the first wearable device via the first interface. The instructions, when executed by the at least one processor individually or collectively, may cause the charging device to obtain a second threshold charging level greater than the first threshold charging level, based on a time interval in which power is provided to the second wearable device via the second interface. The instructions, when executed by the at least one processor individually or collectively, may cause the charging device to identify a battery level of the first wearable device using the first interface, based on the second threshold charging level greater than the first threshold charging level. The instructions, when executed by the at least one processor individually or collectively, may cause the charging device to charge the first wearable device via the first interface and charge the second wearable device via the second interface, based on identifying the battery level of the first wearable device less than the first threshold charging level. The instructions, when executed by the at least one processor individually or collectively, may cause the charging device to charge the second wearable device among the first wearable device and the second wearable device via the second interface, based on identifying the battery level of the first wearable device not less than the first threshold charging level.

As described above, a charging device may comprise a first interface for connecting with a first wearable device. The charging device may comprise a second interface for connecting with a second wearable device. The charging device may comprise memory comprising one or more storage media storing instructions. The charging device may comprise at least one processor comprising processing circuitry. The instructions, when executed by the at least one processor individually or collectively, may cause the charging device to obtain a first threshold charging level corresponding to the first wearable device using the first interface. The instructions, when executed by the at least one processor individually or collectively, may cause the charging device to obtain a second threshold charging level corresponding to the second wearable device using the second interface. The second threshold charging level is greater than the first threshold charging level. The instructions, when executed by the at least one processor individually or collectively, may cause the charging device to, identify a battery level of the first wearable device. The instructions, when executed by the at least one processor individually or collectively, may cause the charging device to, based on identifying that a battery level of the first wearable device is less than the first threshold charging level, provide power to the first wearable device via the first interface and provide power to the second wearable device via the second interface. The instructions, when executed by the at least one processor individually or collectively, may cause the charging device to, based on identifying that the battery level of the first wearable device is not less than the first threshold charging level, provide power only to the second wearable device.

In some examples, the first threshold charging level may be obtained based on first battery information obtained from the first wearable device while the first wearable device is connected to the charging device via the first interface. The second threshold charging level may be obtained based on second battery information obtained from the second wearable device while the second wearable device is connected to the charging device via the second interface.

In some examples, each of the first threshold charging level and the second threshold charging level may be determined based on a usage proportion of second cumulative charging time of the second wearable device to first cumulative charging time of the first wearable device.

In some examples, the power provided to the second wearable device based on identifying that the battery level of the first wearable device may be less than the first threshold charging level is less than the power provided to the second wearable device based on identifying that the battery level of the first wearable device is not less than the first threshold charging level.

In some examples, the charging device may comprise power input circuitry for obtaining external power. The instructions, when executed by the at least one processor individually or collectively, may cause the charging device to, based on identifying that the battery level is not less than the first threshold charging level, refrain from providing power to the first wearable device, and provide the power to the second wearable device via the second interface.

In some examples, the charging device may comprise power input circuitry for obtaining external power. The instructions, when executed by the at least one processor individually or collectively, may cause the charging device to, based on identifying that the battery level of the first wearable device is less than the first threshold charging level, connect the first wearable device and the power input circuitry via the first interface, and connect the second wearable device and the power input circuitry via the second interface. The instructions, when executed by the at least one processor individually or collectively, may cause the charging device to, based on identifying that the battery level of the first wearable device is not less than the first threshold charging level, connect only the second wearable device among the first wearable device and the second wearable device to the power input circuitry via the second interface.

In some examples, the charging device may comprise a battery. The instructions, when executed by the at least one processor individually or collectively, may cause the charging device to, identify that a charging level of the battery is greater than a reference charging level. The instructions, when executed by the at least one processor individually or collectively, may cause the charging device to, based on the charging level of the battery that is greater than the reference charging level, a second battery level of the second wearable device identified using the second interface, and the second threshold charging level, determine the power to be provided to the second wearable device using the battery, and using the battery, provide the power to the second wearable device via the second interface. The instructions, when executed by the at least one processor individually or collectively, may cause the charging device to, after providing the power to the second wearable device using the battery, provide power to the first wearable device via the first interface.

In some examples, the instructions, when executed by the at least one processor individually or collectively, may cause the charging device to, identify that the charging level of the battery is not greater than the reference charging level. The instructions, when executed by the at least one processor individually or collectively, may cause the charging device to, based on the charging level of the battery that is not greater than the reference charging level, obtain power from the first wearable device via the first interface. The instructions, when executed by the at least one processor individually or collectively, may cause the charging device to, based on the obtained power, connect the second wearable device and the first wearable device, via the first interface and the second interface.

In some examples, the instructions, when executed by the at least one processor individually or collectively, may cause the charging device to, when the second wearable device and the first wearable device are connected, obtain first battery information from the first wearable device. The instructions, when executed by the at least one processor individually or collectively, may cause the charging device to, when a third battery level identified from the first battery information is less than the first threshold charging level, disconnect the second wearable device and the first wearable device.

In some examples, the instructions, when executed by the at least one processor individually or collectively, may cause the charging device to, when the second wearable device and the first wearable device are connected, obtain second battery information from the second wearable device. The instructions, when executed by the at least one processor individually or collectively, may cause the charging device to, when a third battery level identified from the second battery information is greater than the second threshold charging level, disconnect the second wearable device and the first wearable device.

As described above, a method performed by a charging device with a first interface for connecting with a first wearable device and a second interface for connecting with a second wearable device may comprise obtaining a first threshold charging level corresponding to the first wearable device using the first interface. The method may comprise obtaining a second threshold charging level corresponding to the second wearable device using the second interface. The second threshold charging level is greater than the first threshold charging level. The method may comprise, identifying a battery level of the first wearable device. The method may comprise, based on identifying that a battery level of the first wearable device is less than the first threshold charging level, providing power to the first wearable device via the first interface and providing power to the second wearable device via the second interface. The method may comprise, based on identifying that the battery level of the first wearable device is not less than the first threshold charging level, providing power only to the second wearable device.

In some examples, the first threshold charging level may be obtained based on first battery information obtained from the first wearable device while the first wearable device is connected to the charging device via the first interface. The second threshold charging level may be obtained based on second battery information obtained from the second wearable device while the second wearable device is connected to the charging device via the second interface.

In some examples, each of the first threshold charging level and the second threshold charging level may be determined based on a usage proportion of second cumulative charging time of the second wearable device to first cumulative charging time of the first wearable device.

In some examples, the power provided to the second wearable device based on identifying that the battery level of the first wearable device may be less than the first threshold charging level is less than the power provided to the second wearable device based on identifying that the battery level of the first wearable device is not less than the first threshold charging level.

In some examples, the charging device may comprise power input circuitry for obtaining external power. The method may comprise based on identifying that the battery level is not less than the first threshold charging level, refraining from providing power to the first wearable device, and provide the power to the second wearable device via the second interface.

In some examples, the charging device may comprise power input circuitry for obtaining external power. The method may comprise based on identifying that the battery level of the first wearable device is less than the first threshold charging level, connecting the first wearable device and the power input circuitry via the first interface, and connecting the second wearable device and the power input circuitry via the second interface. The method may comprise based on identifying that the battery level of the first wearable device is not less than the first threshold charging level, connecting only the second wearable device among the first wearable device and the second wearable device to the power input circuitry via the second interface.

In some examples, the charging device may comprise a battery. The method may comprise identifying that a charging level of the battery is greater than a reference charging level. The method may comprise based on the charging level of the battery that is greater than the reference charging level, a second battery level of the second wearable device identified using the second interface, and the second threshold charging level, determining the power to be provided to the second wearable device using the battery, and using the battery, providing the power to the second wearable device via the second interface. The method may comprise after providing the power to the second wearable device using the battery, providing power to the first wearable device via the first interface.

In some examples, the method may comprise identifying that the charging level of the battery is not greater than the reference charging level. The method may comprise based on the charging level of the battery that is not greater than the reference charging level, obtaining power from the first wearable device via the first interface. The method may comprise based on the obtained power, connecting the second wearable device and the first wearable device, via the first interface and the second interface.

In some examples, the method may comprise when the second wearable device and the first wearable device are connected, obtaining first battery information from the first wearable device. The method may comprise when a third battery level identified from the first battery information is less than the first threshold charging level, disconnecting the second wearable device and the first wearable device.

In some examples, the method may comprise when the second wearable device and the first wearable device are connected, obtaining second battery information from the second wearable device. The method may comprise when a third battery level identified from the second battery information is greater than the second threshold charging level, disconnecting the second wearable device and the first wearable device.

As described above, a non-transitory computer readable storage medium storing one or more programs, the one or more programs may comprise instructions to, when executed by a charging device with a first interface for connecting with a first wearable device and a second interface for connecting with a second wearable device, cause the charging device to obtain a first threshold charging level corresponding to the first wearable device using the first interface. The one or more programs may comprise instructions to, when executed by the charging device, cause the charging device to obtain a second threshold charging level corresponding to the second wearable device using the second interface. The second threshold charging level is greater than the first threshold charging level. The one or more programs may comprise instructions to, when executed by the charging device, cause the charging device to, identify a battery level of the first wearable device. The one or more programs may comprise instructions to, when executed by the charging device, cause the charging device to, based on identifying that a battery level of the first wearable device is less than the first threshold charging level, provide power to the first wearable device via the first interface and provide power to the second wearable device via the second interface. The one or more programs may comprise instructions to, when executed by the charging device, cause the charging device to, based on identifying that the battery level of the first wearable device is not less than the first threshold charging level, provide power only to the second wearable device.

In some examples, the first threshold charging level may be obtained based on first battery information obtained from the first wearable device while the first wearable device is connected to the charging device via the first interface. The second threshold charging level may be obtained based on second battery information obtained from the second wearable device while the second wearable device is connected to the charging device via the second interface.

In some examples, each of the first threshold charging level and the second threshold charging level may be determined based on a usage proportion of second cumulative charging time of the second wearable device to first cumulative charging time of the first wearable device.

In some examples, the power provided to the second wearable device based on identifying that the battery level of the first wearable device may be less than the first threshold charging level is less than the power provided to the second wearable device based on identifying that the battery level of the first wearable device is not less than the first threshold charging level.

In some examples, the charging device may comprise power input circuitry for obtaining external power. The one or more programs may comprise instructions to, when executed by the charging device, cause the charging device to, based on identifying that the battery level is not less than the first threshold charging level, refrain from providing power to the first wearable device, and provide the power to the second wearable device via the second interface.

In some examples, the charging device may comprise power input circuitry for obtaining external power. The one or more programs may comprise instructions to, when executed by the charging device, cause the charging device to, based on identifying that the battery level of the first wearable device is less than the first threshold charging level, connect the first wearable device and the power input circuitry via the first interface, and connect the second wearable device and the power input circuitry via the second interface. The one or more programs may comprise instructions to, when executed by the charging device, cause the charging device to, based on identifying that the battery level of the first wearable device is not less than the first threshold charging level, connect only the second wearable device among the first wearable device and the second wearable device to the power input circuitry via the second interface.

In some examples, the charging device may comprise a battery. The one or more programs may comprise instructions to, when executed by the charging device, cause the charging device to, identify that a charging level of the battery is greater than a reference charging level. The one or more programs may comprise instructions to, when executed by the charging device, cause the charging device to, based on the charging level of the battery that is greater than the reference charging level, a second battery level of the second wearable device identified using the second interface, and the second threshold charging level, determine the power to be provided to the second wearable device using the battery, and using the battery, provide the power to the second wearable device via the second interface. The one or more programs may comprise instructions to, when executed by the charging device, cause the charging device to, after providing the power to the second wearable device using the battery, provide power to the first wearable device via the first interface.

In some examples, The one or more programs may comprise instructions to, when executed by the charging device, cause the charging device to, identify that the charging level of the battery is not greater than the reference charging level. The one or more programs may comprise instructions to, when executed by the charging device, cause the charging device to, based on the charging level of the battery that is not greater than the reference charging level, obtain power from the first wearable device via the first interface. The one or more programs may comprise instructions to, when executed by the charging device, cause the charging device to, based on the obtained power, connect the second wearable device and the first wearable device, via the first interface and the second interface.

In some examples, The one or more programs may comprise instructions to, when executed by the charging device, cause the charging device to, when the second wearable device and the first wearable device are connected, obtain first battery information from the first wearable device. The one or more programs may comprise instructions to, when executed by the charging device, cause the charging device to, when a third battery level identified from the first battery information is less than the first threshold charging level, disconnect the second wearable device and the first wearable device.

In some examples, The one or more programs may comprise instructions to, when executed by the charging device, cause the charging device to, when the second wearable device and the first wearable device are connected, obtain second battery information from the second wearable device. The one or more programs may comprise instructions to, when executed by the charging device, cause the charging device to, when a third battery level identified from the second battery information is greater than the second threshold charging level, disconnect the second wearable device and the first wearable device.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

**Claims**

**1.** A charging device comprising:

a first interface for connecting with a first wearable device;
a second interface for connecting with a second wearable device;
at least one processor comprising processing circuitry; and
memory comprising one or more storage media storing instructions that, when executed by the at least one processor individually or collectively, cause the charging device to:

obtain a first threshold charging level corresponding to the first wearable device using the first interface,
obtain a second threshold charging level corresponding to the second wearable device using the second interface, wherein the second threshold charging level is greater than the first threshold charging level, identify a battery level of the first wearable device,
based on identifying that the battery level of the first wearable device is less than the first threshold charging level, provide power to the first wearable device via the first interface and provide power to the second wearable device via the second interface, and
based on identifying that the battery level of the first wearable device is not less than the first threshold charging level, provide power only to the second wearable device via the second interface.

2. The charging device of claim 1,

wherein the first threshold charging level is obtained based on first battery information obtained from the first wearable device while the first wearable device is connected to the charging device via the first interface, and wherein the second threshold charging level is obtained based on second battery information obtained from the second wearable device while the second wearable device is connected to the charging device via the second interface.

3. The charging device of claim 2,
wherein each of the first threshold charging level and the second threshold charging level is determined based on a usage proportion of second cumulative charging time of the second wearable device to first cumulative charging time of the first wearable device.

4. The charging device of claim 1,
wherein the power provided to the second wearable device based on identifying that the battery level of the first wearable device is less than the first threshold charging level is less than the power provided to the second wearable device based on identifying that the battery level of the first wearable device is not less than the first threshold charging level.

5. The charging device of claim 1, wherein the instructions, when executed by the at least one processor individually or collectively, cause the charging device to:
based on identifying that the battery level is not less than the first threshold charging level, refrain from providing power to the first wearable device, and provide the power to the second wearable device via the second interface.

6. The charging device of claim 1, further comprising:

power input circuitry for obtaining external power;
wherein the instructions, when executed by the at least one processor individually or collectively, cause the charging device to:

based on identifying that the battery level of the first wearable device is less than the first threshold charging level, connect the first wearable device and the power input circuitry via the first interface, and connect the second wearable device and the power input circuitry via the second interface, and
based on identifying that the battery level of the first wearable device is not less than the first threshold charging level, connect only the second wearable device among the first wearable device and the second wearable device to the power input circuitry via the second interface.

7. The charging device of claim 1, further comprising:

a battery;
wherein the instructions, when executed by the at least one processor individually or collectively, cause the charging device to:

identify that a charging level of the battery is greater than a reference charging level,
based on the charging level of the battery that is greater than the reference charging level, a second battery level of the second wearable device identified using the second interface, and the second threshold charging level, determine the power to be provided to the second wearable device using the battery, and using the battery, provide the power to the second wearable device via the second interface, and
after providing the power to the second wearable device using the battery, provide power to the first wearable device via the first interface.

8. The charging device of claim 7, wherein the instructions, when executed by the at least one processor individually or collectively, cause the charging device to:

identify that the charging level of the battery is not greater than the reference charging level,
based on the charging level of the battery that is not greater than the reference charging level, obtain power from the first wearable device via the first interface, and
based on the obtained power, connect the second wearable device and the first wearable device, via the first interface and the second interface.

9. The charging device of claim 8, wherein the instructions, when executed by the at least one processor individually or collectively, cause the charging device to:

when the second wearable device and the first wearable device are connected, obtain first battery information from the first wearable device, and
when a third battery level identified from the first battery information is less than the first threshold charging level, disconnect the second wearable device and the first wearable device.

10. The charging device of claim 8, wherein the instructions, when executed by the at least one processor individually or collectively, cause the charging device to:

when the second wearable device and the first wearable device are connected, obtain second battery information from the second wearable device, and
when a third battery level identified from the second battery information is greater than the second threshold charging level, disconnect the second wearable device and the first wearable device.

11. A method performed by a charging device with a first interface for connecting with a first wearable device and a second interface for connecting with a second wearable device, the method comprising:

obtaining a first threshold charging level corresponding to the first wearable device using the first interface,
obtaining a second threshold charging level corresponding to the second wearable device using the second interface, wherein the second threshold charging level is greater than the first threshold charging level,
identifying a battery level of the first wearable device,
based on identifying that the battery level of the first wearable device is less than the first threshold charging level, providing power to the first wearable device via the first interface and providing power to the second wearable device via the second interface, and
based on identifying that the battery level of the first wearable device is not less than the first threshold charging level, providing power only to the second wearable device via the second interface.

12. The method of claim 11,

wherein the first threshold charging level is obtained based on first battery information obtained from the first wearable device while the first wearable device is connected to the charging device via the first interface, and
wherein the second threshold charging level is obtained based on second battery information obtained from the second wearable device while the second wearable device is connected to the charging device via the second interface.

13. The method of claim 12,
wherein each of the first threshold charging level and the second threshold charging level is determined based on a usage proportion of second cumulative charging time of the second wearable device to first cumulative charging time of the first wearable device.

14. The method of claim 11,
wherein the power provided to the second wearable device based on identifying that the battery level of the first wearable device is less than the first threshold charging level is less than the power provided to the second wearable device based on identifying that the battery level of the first wearable device is not less than the first threshold charging level.

15. The method of claim 11, further comprising:

based on identifying that the battery level is not less than the first threshold charging level, refraining from providing power to the first wearable device, and provide the power to the second wearable device via the second interface.

100

ELECTRONIC DEVICE 101

INPUT MODULE 150

SOUND OUTPUT MODULE 155

DISPLAY MODULE 160

MEMORY 130

VOLATILE MEMORY 132

NON-VOLATILE MEMORY 134

INTERNAL MEMORY 136

EXTERNAL MEMORY 138

BATTERY 189

PROCESSOR 120

COMMUNICATION MODULE 190

WIRELESS COMMUNICATION MODULE 192

WIRED COMMUNICATION MODULE 194

MAIN PROCESSOR 121

POWER MANAGE-MENT MODULE 188

AUXILIARY PROCESSOR 123

SUBSCRIBER IDENTIFICATION MODULE 196

ANTENNA MODULE 197

AUDIO MODULE 170

SENSOR MODULE 176

INTERFACE 177

CONNECTING TERMINAL 178

HAPTIC MODULE 179

CAMERA MODULE 180

PROGRAM 140

APPLICATION 146

MIDDLEWARE 144

OPERATING SYSTEM 142

SECOND NETWORK 199

ELECTRONIC DEVICE 104

FIRST NETWORK 198

ELECTRONIC DEVICE 102

SERVER 108

FIG. 1

CHARGING DEVICE (201)

AT LEAST ONE PROCESSOR (200) ↔ BATTERY (230)

MEMORY (210) ↔ PMIC (240)

POWER INPUT CIRCUITRY (220) ↔ FIRST INTERFACE (251)

SECOND INTERFACE (252)

261

262

FIG. 2

FIG. 3

~401

OBTAIN FIRST THRESHOLD CHARGING LEVEL
CORRESPONDING TO FIRST WEARABLE DEVICE

~403

OBTAIN SECOND THRESHOLD CHARGING LEVEL
CORRESPONDING TO SECOND WEARABLE DEVICE

~405

IDENTIFY SECOND THRESHOLD CHARGING LEVEL
GREATER THAN FIRST THRESHOLD CHARGING LEVEL

407

BATTERY LEVEL OF FIRST
WEARABLE DEVICE IS GREATER THAN
FIRST THRESHOLD CHARGING
LEVEL?

NO

YES

~409

PROVIDE POWER TO ONLY SECOND WEARABLE
DEVICE AMONG FIRST WEARABLE DEVICE
AND SECOND WEARABLE DEVICE

~411

PROVIDE POWER TO FIRST
WEARABLE DEVICE, AND PROVIDE POWER
TO SECOND WEARABLE DEVICE

FIG. 4

500

| HEADER | | | | TYPE | DATA | | | | | | | |
|---|---|---|---|---|---|---|---|---|---|---|---|---|
| 3 | 2 | 1 | 0 | | 7 | 6 | 5 | 4 | 3 | 2 | 1 | 0 |
| 0 | 0 | 1 | 0 | FIRST TYPE (510) | BUFFER DATA (511) | SAFETY TIMER (513) | | TEMPERATURE STATUS (515) | | BATTERY VOLTAGE CODE (517) | | |
| 0 | 0 | 1 | 1 | SECOND TYPE (520) | SOC DATA (521) | | | | | | | |
| 1 | 0 | 1 | 1 | THIRD TYPE (530) | | SAFETY TIMER (533) | | TEMPERATURE STATUS (535) | | BATTERY VOLTAGE CODE (537) | | |

FIG. 5A

IDENTIFY THAT FIRST WEARABLE DEVICE IS CONNECTED AND SECOND WEARABLE DEVICE IS CONNECTED — 541

OBTAIN FIRST BATTERY INFORMATION FROM FIRST WEARABLE DEVICE, AND OBTAIN SECOND BATTERY INFORMATION FROM SECOND WEARABLE DEVICE — 543

DETERMINE EACH OF FIRST THRESHOLD CHARGING LEVEL AND SECOND THRESHOLD CHARGING LEVEL, BASED ON USAGE PROPORTION OF SECOND CUMULATIVE CHARGING TIME RELATIVE TO FIRST CUMULATIVE CHARGING TIME — 545

FIG. 5B

FIG. 6

~701

OBTAIN EXTERNAL POWER

703

FIRST
BATTERY LEVEL OF
FIRST WEARABLE DEVICE IS GREATER THAN
FIRST THRESHOLD CHARGING
LEVEL?

NO

YES

705

SECOND
THRESHOLD CHARGING
LEVEL IS HIGHER THAN SECOND BATTERY LEVEL
OF SECOND WEARABLE
DEVICE?

NO

YES

~707

PROVIDE POWER TO ONLY SECOND WEARABLE
DEVICE AMONG FIRST WEARABLE DEVICE
AND SECOND WEARABLE DEVICE

FIG. 7

EP 4 787 663 A1

**801** DETERMINE THAT CHARGING LEVEL OF BATTERY IS GREATER THAN REFERENCE CHARGING LEVEL

**803** SECOND THRESHOLD CHARGING LEVEL IS HIGHER THAN SECOND BATTERY LEVEL OF SECOND WEARABLE DEVICE?

NO

YES

**809** FIRST THRESHOLD CHARGING LEVEL IS HIGHER THAN FIRST BATTERY LEVEL OF FIRST WEARABLE DEVICE?

NO

YES

**805** DETERMINE AMOUNT OF POWER TO BE PROVIDED USING BATTERY, BASED ON CHARGING LEVEL OF BATTERY, SECOND BATTERY LEVEL, AND SECOND THRESHOLD CHARGING LEVEL

**811** DETERMINE AMOUNT OF POWER TO BE PROVIDED USING BATTERY, BASED ON CHARGING LEVEL OF BATTERY, FIRST BATTERY LEVEL, AND FIRST THRESHOLD CHARGING LEVEL

**815** PROVIDE POWER TO FIRST WEARABLE DEVICE AND SECOND WEARABLE DEVICE, BY USING BATTERY

**807** PROVIDE POWER TO SECOND WEARABLE DEVICE BY USING BATTERY, BASED ON DETERMINED AMOUNT

**813** PROVIDE POWER TO FIRST WEARABLE DEVICE BY USING BATTERY, BASED ON DETERMINED AMOUNT

FIG. 8

901

DETERMINE THAT CHARGING LEVEL OF BATTERY
IS NOT HIGHER THAN REFERENCE CHARGING LEVEL

903

SECOND THRESHOLD
CHARGING LEVEL IS HIGHER THAN SECOND
BATTERY LEVEL OF SECOND
WEARABLE DEVICE?

NO

YES

905

FIRST BATTERY LEVEL
OF FIRST WEARABLE DEVICE IS HIGHER THAN
FIRST THRESHOLD CHARGING
LEVEL?

NO

YES

907

CONNECT SECOND WEARABLE DEVICE
AND FIRST WEARABLE DEVICE, BASED ON POWER
OBTAINED FROM FIRST WEARABLE DEVICE

FIG. 9

FIG. 10

FIRST WEARABLE DEVICE (301)

CHARGING DEVICE (201)

AT LEAST ONE PROCESSOR (1100)

BATTERY (332)

MEMORY (1110)

PMIC (330)

SECOND WEARABLE DEVICE (302)

FIG. 11

**TRANSLATION**

## INTERNATIONAL SEARCH REPORT

| International application No. |
|---|
| **PCT/KR2025/011740** |

**A. CLASSIFICATION OF SUBJECT MATTER**

**H02J 7/00**(2006.01)i; **G01R 19/165**(2006.01)i; **H04R 1/10**(2006.01)i; **H02J 7/34**(2006.01)i

According to International Patent Classification (IPC) or to both national classification and IPC

**B. FIELDS SEARCHED**

Minimum documentation searched (classification system followed by classification symbols)

H02J 7/00(2006.01); A45C 11/00(2006.01); G01R 31/36(2006.01); G01R 31/382(2019.01); H02J 9/00(2006.01); H04R 1/10(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 이어버즈(earbuds), 충전(charging), 배터리 레벨(battery level), 임계 충전 레벨 (threshold charging level), 누적 충전 시간(accumulated charging time)

**C. DOCUMENTS CONSIDERED TO BE RELEVANT**

| Category* | Citation of document, with indication, where appropriate, of the relevant passages | Relevant to claim No. |
|---|---|---|
| X | KR 10-2023-0094917 A (SAMSUNG ELECTRONICS CO., LTD.) 28 June 2023 (2023-06-28) paragraphs [0046], [0080]-[0087], [0097], [0103]-[0122]; and figures 3-5 | 1-2,4-7,11-12,14-15 |
| Y | | 8-10 |
| A | | 3,13 |
| Y | KR 10-2022-0048379 A (SAMSUNG ELECTRONICS CO., LTD.) 19 April 2022 (2022-04-19) paragraphs [0130]-[0132], [0144]; and figure 10 | 8-10 |
| A | KR 10-2071268 B1 (BLUECOM CO., LTD.) 30 January 2020 (2020-01-30) paragraphs [0041]-[0061]; and figures 5-7 | 1-15 |
| A | US 11089398 B1 (APPLE INC.) 10 August 2021 (2021-08-10) claims 1-27 | 1-15 |

☑ Further documents are listed in the continuation of Box C. ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **21 November 2025** | **23 November 2025** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 787 663 A1**

### INTERNATIONAL SEARCH REPORT

International application No.

**PCT/KR2025/011740**

| C. | DOCUMENTS CONSIDERED TO BE RELEVANT | |
|---|---|---|
| Category* | Citation of document, with indication, where appropriate, of the relevant passages | Relevant to claim No. |
| A | US 2024-0250538 A1 (HONOR DEVICE CO., LTD.) 25 July 2024 (2024-07-25)<br>paragraphs [0004]-[0031] | 1-15 |

Form PCT/ISA/210 (second sheet) (July 2022)

**INTERNATIONAL SEARCH REPORT**
**Information on patent family members**

International application No.

**PCT/KR2025/011740**

| Patent document cited in search report | | | Publication date (day/month/year) | Patent family member(s) | | | Publication date (day/month/year) |
|---|---|---|---|---|---|---|---|
| KR | 10-2023-0094917 | A | 28 June 2023 | US | 2024-0267666 | A1 | 08 August 2024 |
| | | | | WO | 2023-121215 | A1 | 29 June 2023 |
| KR | 10-2022-0048379 | A | 19 April 2022 | WO | 2022-080684 | A1 | 21 April 2022 |
| KR | 10-2071268 | B1 | 30 January 2020 | | None | | |
| US | 11089398 | B1 | 10 August 2021 | DE | 102021110660 | A1 | 16 December 2021 |
| | | | | FR | 3111481 | A1 | 17 December 2021 |
| | | | | FR | 3111481 | B1 | 21 March 2025 |
| | | | | GB | 2596401 | A | 29 December 2021 |
| | | | | GB | 2596401 | B | 23 November 2022 |
| | | | | US | 11984749 | B2 | 14 May 2024 |
| | | | | US | 2021-391739 | A1 | 16 December 2021 |
| US | 2024-0250538 | A1 | 25 July 2024 | CN | 114865755 | A | 05 August 2022 |
| | | | | CN | 114865755 | B | 18 November 2022 |
| | | | | EP | 4329141 | A1 | 28 February 2024 |
| | | | | EP | 4329141 | A4 | 06 November 2024 |
| | | | | EP | 4329141 | B1 | 08 October 2025 |
| | | | | WO | 2024-007687 | A1 | 11 January 2024 |

Form PCT/ISA/210 (patent family annex) (July 2022)